(19) Europäisches Patentamt
European Patent Office
Office européen des brevets

(11) **EP 4 682 882 A2**

(12) **EUROPEAN PATENT APPLICATION**

(43) Date of publication:
**21.01.2026 Bulletin 2026/04**

(21) Application number: **25189291.5**

(22) Date of filing: **14.07.2025**

(51) International Patent Classification (IPC):
**G11C 11/406** (2006.01)  **G11C 11/403** (2006.01)

(52) Cooperative Patent Classification (CPC):
**G11C 11/40618; G11C 11/403; G11C 11/40603;**
G11C 2211/4065

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **19.07.2024 KR 20240095546
23.09.2024 KR 20240128572
29.10.2024 KR 20240149507
27.02.2025 KR 20250026207
19.06.2025 KR 20250081281**

(71) Applicant: **Samsung Electronics Co., Ltd.
Suwon-si, Gyeonggi-do 16677 (KR)**

(72) Inventors:
• **KIM, Chinam**
  **16677 Suwon-si, Gyeonggi-do (KR)**
• **KIM, Kwangsu**
  **16677 Suwon-si, Gyeonggi-do (KR)**
• **KIM, Do-Han**
  **16677 Suwon-si, Gyeonggi-do (KR)**
• **KIM, Dong-Yoon**
  **16677 Suwon-si, Gyeonggi-do (KR)**
• **KIM, SuJin**
  **16677 Suwon-si, Gyeonggi-do (KR)**
• **CHO, Sangwook**
  **16677 Suwon-si, Gyeonggi-do (KR)**

(74) Representative: **Kuhnen & Wacker
Patent- und Rechtsanwaltsbüro PartG mbB
Prinz-Ludwig-Straße 40A
85354 Freising (DE)**

(54) **MEMORY DEVICE AND OPERATION METHOD THEREOF**

(57)    According to embodiments of the present disclosure, an operation method of a memory device including a memory bank (140; 240; BNKa to BNKd), which includes a plurality of edge memory cell arrays (141_1, 141_n) and a plurality of internal memory cell arrays (141_2 to 141_n-1) arranged between the plurality of edge memory cell arrays (141_1, 141_n) may be provided. The operation method may comprise receiving (S210) a fine-grained refresh command (REF_F), identifying (S210) a refresh target pointer value (PT_TG) for a refresh target determination list (LST), which includes a plurality of row addresses for the memory bank(140; 240; BNKa to BNKd), identifying (S230) a pointed row address (RA_PTD) corresponding to the refresh target pointer value (PT_TG), among the plurality of row addresses, determining (S240) a first memory cell array type corresponding to the pointed row address (RA_PTD), and performing (S250, S270) a first refresh operation for a refresh target number of fine-grained refresh target row addresses (RA_TG), wherein the refresh target number is determined based on the first memory cell array type.

FIG. 15

EP 4 682 882 A2

## Description

### FIELD

The present disclosure relates to a semiconductor memory device. More specifically, the present disclosure relates to a volatile memory device and an operation method thereof.

### BACKGROUND

Volatile memory devices such as a dynamic random access memory (DRAM) may store a data in a form of charges charged in memory cells. The charges charged in the memory cells of the volatile memory device may leak due to various reasons. Accordingly, the volatile memory device may perform a refresh operation to recharge the charges charged in the memory cells.

Due to recent trends in the volatile memory devices toward a higher integration, a higher capacity, and higher input/output speeds, the ratio for the entire operating time of the volatile memory device of the time spent on the refresh operations is gradually increasing. That is, there occurs a problem in which the input/output performance of the volatile memory device being limited by the refresh operation.

### SUMMARY

The present disclosure is intended to solve the technical problems described above. More specifically, the present disclosure is for providing a memory device, which performs a plurality of fine-grained refresh operations instead of regular refresh operation, and an operation method thereof.

According to embodiments of the present disclosure, an operation method of a memory device including a memory bank, which includes a plurality of edge memory cell arrays and a plurality of internal memory cell arrays arranged between the plurality of edge memory cell arrays may be provided. The operation method may comprise: receiving a fine-grained refresh command; identifying a refresh target pointer value for a refresh target determination list, which includes a plurality of row addresses for the memory bank; identifying a pointed row address corresponding to the refresh target pointer value, among the plurality of row addresses; determining a first memory cell array type corresponding to the pointed row address; and performing a first refresh operation for a refresh target number of fine-grained refresh target row addresses, wherein the refresh target number is determined based on the first memory cell array type.

According to embodiments of the present disclosure, a memory device communicating with an external device may be provided. The memory device may comprise: a memory bank; a row decoder connected to the memory bank; and a control logic circuit configured to manage a refresh target pointer value and a refresh target determination list including a plurality of row addresses, wherein the control logic circuit is configured to: determine, based on the refresh target pointer value and the refresh target determination list, a plurality of regular refresh target row addresses corresponding to a regular refresh command provided from the external device; and determine, based on the refresh target pointer value and the refresh target determination list, one or more fine-grained refresh target row addresses corresponding to a fine-grained refresh command provided from the external device, wherein a number of the plurality of regular refresh target row addresses is greater than a number of the one or more fine-grained refresh target row addresses.

According to embodiments of the present disclosure, a memory device may be provided. The memory device may comprise: a first memory bank; a row decoder connected to the first memory bank; and a control logic circuit configured to: perform a regular refresh operation for the memory bank for a first time period, by controlling the row decoder in response to a first regular refresh command for the first memory bank; and perform a fine-grained refresh operation for the memory bank for a second time period shorter than the first time period, by controlling the row decoder in response to a first fine-grained refresh command for to the first memory bank.

According to embodiments of the present disclosure, a memory controller may be provided. The memory controller may comprise: a command issuance circuit; a refresh debit counter configured to manage a refresh debit count for the first memory bank; and a refresh scheduling circuit configured to determine commands to be issued by the command issuance circuit based on the refresh debit count, wherein the refresh debit counter is configured to: decrease the refresh debit count by a first value whenever the command issuance circuit issues a regular refresh command for the first memory bank; and decrease the refresh debit count by a second value less than the first value whenever the command issuance circuit issues a fine-grained refresh command for the first memory bank.

According to embodiments, a method of manufacturing a memory device may comprise: providing a memory bank; providing a row decoder connected to the memory bank; and providing a control logic circuit configured to manage a refresh target pointer value and a refresh target determination list including a plurality of row addresses, wherein the control logic circuit is configured to: determine, based on the refresh target pointer value and the refresh target determination list, a plurality of regular refresh target row addresses corresponding to a regular refresh command provided from the external device; and determine, based on the refresh target pointer value and the refresh target determination list, one or more fine-grained refresh target row addresses corresponding to a fine-grained refresh command provided from the external device, wherein a number of the plurality of regular refresh target row addresses is greater than a number of the one or more fine-grained refresh target row addresses.

## BRIEF DESCRIPTION OF THE DRAWINGS

FIG. 1 is a block diagram showing a memory system according to embodiments of the present disclosure.
FIG. 2 is a diagram showing how a regular refresh operation is performed for one memory bank.
FIG. 3 is a diagram showing the operation of the refresh scheduling circuit of FIG. 1.
FIG. 4 is a diagram showing the operation of the refresh scheduling circuit of FIG. 1.
FIG. 5 is a block diagram showing the memory device of FIG. 1 in more detail.
FIG. 6 is a drawing showing some configurations of FIG. 5 in more detail.
FIG. 7 is a diagram showing in more detail how the refresh operation is performed.
FIG. 8 is a timing diagram showing an operation of the memory device in response to the regular refresh command according to embodiments of the present disclosure.
FIG. 9 is a timing diagram showing an operation of the memory device in response to a fine-grained refresh command according to embodiments of the present disclosure.
FIGS. 10 and 11 are drawings showing the operation of the memory system according to embodiments.
FIGS. 12 and 13 are diagrams showing an operation of the memory system according to embodiments.
FIG. 14 is a flowchart showing an operation method of a memory device in response to a regular refresh command.
FIG. 15 is a flowchart showing an operation method of the memory device in response to a fine-grained refresh command.
FIGS. 16 and 17 are timing diagrams showing operations of the memory system according to embodiments.
FIG. 18 is a timing diagram showing an operation of the memory system according to embodiments.
FIG. 19 is a graph showing an effect of fine-grained refresh according to embodiments of the present disclosure.
FIG. 20 is a flowchart showing regular refresh scheduling of the host device according to embodiments.
FIG. 21 is a diagram showing fine-grained refresh scheduling of the host device according to embodiments.
FIG. 22 is a diagram showing an operation of the memory system according to embodiments.
FIG. 23 is a flowchart showing an operation method of the memory device in response to a fine-grained refresh command, when the refresh target determination list is implemented in a manner described with reference to FIG. 22.
FIG. 24 is a block diagram showing a memory system according to embodiments.
FIG. 25 is a timing diagram showing how the memory device of FIG. 24 manages the refresh credit count.
FIG. 26 is a block diagram showing a memory system according to embodiments.
FIG. 27 is a timing diagram showing an operation of the memory system according to the embodiment of FIG. 26.

## DETAILED DESCRIPTION

Hereinafter, embodiments of the present disclosure will be described in detail to an extent that a person skilled in an art of the present disclosure may easily practice the present disclosure.

The components described below may be implemented as various types of software such as firmware, applications, etc., or may be implemented as various types of hardware such as electric circuits, electronic circuits, processors, etc. However, the scope of the present disclosure is not limited thereto, and the components described below may also be implemented as a combination of software and hardware.

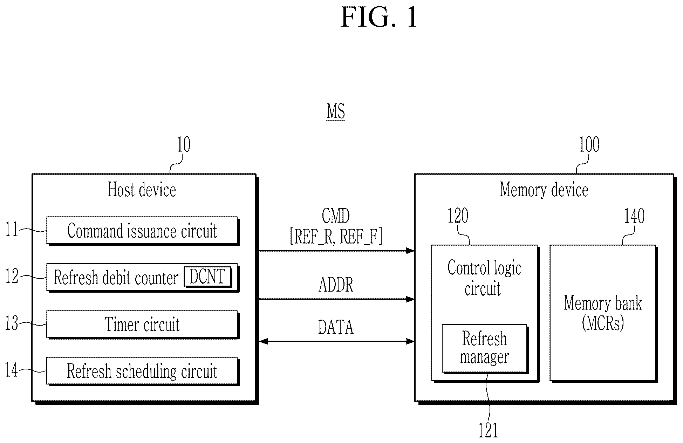

FIG. 1 is a block diagram showing a memory system according to embodiments of the present disclosure. Referring to FIG. 1, a memory system MS may include a host device 10 and a memory device 100.

The host device 10 may control the memory device 100 by issuing various types of command CMD and address ADDR. For example, the host device 10 may issue a read command to read a data DATA from the memory device 100, or issue a write command to store a data DATA in the memory device 100.

In embodiments, the host device 10 may issue various types of command CMD and address ADDR in a form of command/address signals (hereinafter, it may be referred to as "CA").

In embodiments, the host device 10 may be included in one of various types of processing units, such as a central processing unit (CPU), a graphic processing unit (GPU), and the like.

In embodiments, the host device 10 may be referred to as a memory controller. However, the scope of the present disclosure is not limited such terms.

The memory device 100 may include a memory bank 140. The memory bank 140 may store data DATA. For example, the memory bank 140 may include a plurality of memory cell rows MCR. Each of the plurality of memory cell rows MCR may include a plurality of memory cells.

Each of the plurality of memory cells included in the memory bank 140 may store a data in a form of charges charged to a capacitor. However, the amount of the charges charged to each of the plurality of memory cells may change over time, and the data stored in the memory bank 140 may be damaged. Accordingly, the memory device 100 may perform a refresh operation on the plurality of memory cells in response to the control of the host device 10, so that the amount of the charges stored in each of the plurality of memory cells may be maintained. Hereinafter, how the memory device 100 performs the refresh operation in response to the control from the host device 10 will be described.

The memory device 100 may include a control logic circuit 120. The control logic circuit 120 may control an overall operation of the memory device 100. For example, the control logic circuit 120 may perform a regular refresh operation for the memory bank 140 in response to a regular refresh command REF_R provided from the host device 10, or may perform a fine-grained refresh operation for the memory bank 140 in response to a fine-grained refresh command REF_F provided from the host device 10.

The control logic circuit 120 may include a refresh manager 121. The refresh manager 121 may manage the details of how the refresh operations are performed on the memory device 100. For example, the refresh manager 121 may determine refresh order for the plurality of memory cells included in the memory bank 140.

In embodiments, the refresh manager 121 may be referred to as a refresh management circuit. However, the scope of the present disclosure is not limited to these terms.

In embodiments, a number of memory cell rows MCR refreshed when the fine-grained refresh operation is performed may be less than a number of memory cell rows MCR refreshed when the regular refresh operation is performed.

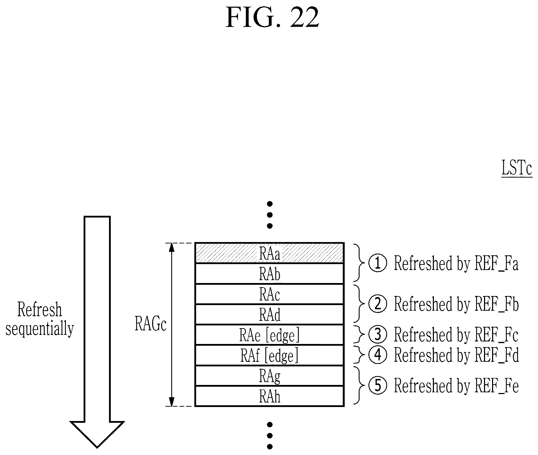

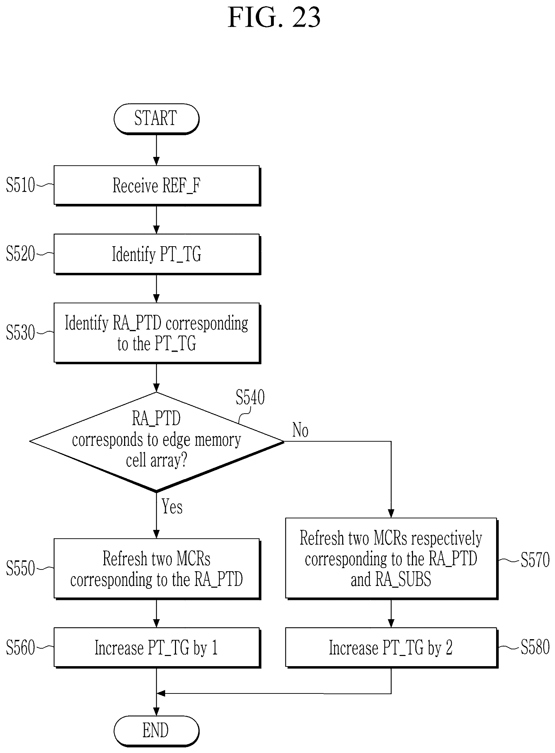

In embodiments, the number of memory cell rows MCR refreshed when the fine-grained refresh operation is performed may be less than or equal to a number of wordlines (hereinafter referred to as "WLs") connected to the memory bank 140 that the control logic circuit 120 can simultaneously activate in response to an activation command (hereinafter referred to as "ACT") provided from the host device 10 (hereinafter, such number may be referred to as "maximum number of concurrently active wordlines for activation command"). For example, the 'maximum number of concurrently active wordlines for activation command' may be 2. In this case, the number of memory cell rows MCR being refreshed when the fine-grained refresh operation is performed may be 1 or 2. However, the scope of the present disclosure is not limited thereto. For example, the control logic circuit 120 may be implemented to refresh a number of memory cell rows MCR equal to the 'maximum number of concurrently active wordlines for activation command' whenever a fine-grained refresh command REF_F is received. Embodiments in which the control logic circuit 120 is implemented to refresh a number of memory cell rows MCR equal to the 'maximum number of simultaneous active wordlines for activation command' whenever a fine-grained refresh command REF_F is received is described in more detail with reference to FIGS. 22 and 23 below.

In embodiments, the number of memory cell rows MCR being refreshed when the regular refresh operation is performed may be eight or more. However, the scope of the present disclosure is not limited to the number of specific memory cell rows MCRs that are refreshed when the regular refresh operation is performed. For example, when the regular refresh operation is performed, the number of memory cell rows being refreshed may be 4 or more, or 16 or more.

The host device 10 may include a command issuance circuit 11, a refresh debit counter 12, a timer circuit 13, and a refresh scheduling circuit 14.

The command issuance circuit 11 may issue various types of commands CMD for controlling the memory device 100. For example, the command issuance circuit 11 may issue various types of commands CMDs, such as an activation command ACT, a precharge command (hereinafter referred to as "PREC"), a read command, a write command, the regular refresh command REF_R, the fine-grained refresh command REF_F, etc., to the memory device 100.

The command issuance circuit 11 may issue the regular refresh command REF_R at every regular refresh period. The memory device 100 may refresh some memory cell rows MCR included in the memory bank 140 in response to the regular refresh command REF_R. In this way, the host device 10 may maintain an integrity of data stored in the memory device 100 by repeatedly issuing the regular refresh command REF_R.

However, the command issuance circuit 11 may not issue the regular refresh command REF_R in a specific regular refresh period, under the control of the refresh scheduling circuit 15. That is, at the specific regular refresh period, the command issuance circuit 11 may skip issuing the regular refresh command REF_R in response to the control of the refresh scheduling circuit 15. In this case, the host device 10 may issue another command instead of issuing the regular refresh command REF_R, which may improve the operation efficiency of the memory system MS. For example, if the memory device 100 does not perform the regular refresh operations, the host device 10 may be able to perform input/output operations to the memory device 100.

The manner in which the command issuance circuit 11 skip issuing the regular refresh command REF_R in response to the control of the refresh scheduling circuit 15 is described in detail below.

The refresh debit counter 12 may manage a refresh debit count DCNT. The refresh debit count DCNT may indicate a level how a refresh operation is required for the memory bank 140.

The refresh debit counter 12 may decrease the refresh debit count DCNT whenever the command issuance circuit 11 issues a command instructing the refresh operation for the memory bank 140. For example, the refresh debit counter 12 may decrease the refresh debit count DCNT whenever the command issuance circuit 11 issues the regular refresh command REF_R to the memory bank 140 or the fine-grained refresh command REF_F to the memory bank 140.

The refresh debit counter 12 may increase the refresh debit count DCNT at every regular refresh period.

The timer circuit 13 may detect the regular refresh period. For example, the timer circuit 13 may generate a 'regular refresh period notification' whenever a time length corresponding to the regular refresh period elapses. The timer circuit 13 may provide the 'regular refresh period notification' to other components of the host device 10. Therefore, each component of the host device 10 may identify the regular refresh period based on the timer circuit 13.

The refresh scheduling circuit 14 may control the operation of the command issuance circuit 11 based on the refresh debit count DCNT. For example, the refresh scheduling circuit 14 may determine whether the command issuance circuit 11 skips issuing the regular refresh command REF_R during each regular refresh period based on the refresh debit count DCNT. More specifically, the refresh scheduling circuit 14 may determine level of need for the refresh operation for the memory bank 140 based on the refresh debit count DCNT. When the level of need for the refresh operation for the memory bank 140 is low (e.g., when the refresh debit count DCNT is a sufficiently low value), the refresh scheduling circuit 14 may control the command issuance circuit 11 to skip issuing the regular refresh command REF_R.

That is, according to an exemplary embodiment of the present disclosure, when the command issuance circuit 11 has already issued a sufficient number of fine-grained refresh commands REF_F for the memory bank 140, the refresh scheduling circuit 14 may control the command issuance circuit 11 to skip issuing the regular refresh command REF_R. In this case, the integrity of data stored in the memory device 100 is guaranteed, while the time taken for the memory device 100 to perform the regular refresh operation may be reduced. In this case, time allowed for the host device 10 to access the memory bank 140 may be increased, so the operating efficiency of the memory system MS may be improved.

In embodiments, the command structures of the regular refresh command REF_R and the fine-grained refresh command REF_F may be different. For example, a combination of command/address signals CA representing the regular refresh command REF_R may be different from a combination of command/address signals CA representing the fine-grained refresh command REF_F. That is, the host device 10 may flexibly issue the regular refresh command REF_R and the fine-grained refresh command REF_F without changing an operation mode of the memory device 100. For example, the host device 10 may issue both of the regular refresh command REF_R and the fine-grained refresh command REF_F while the mode register values stored in the mode register array included in the memory device 100 maintained constantly. However, the scope of the present disclosure is not limited thereto.

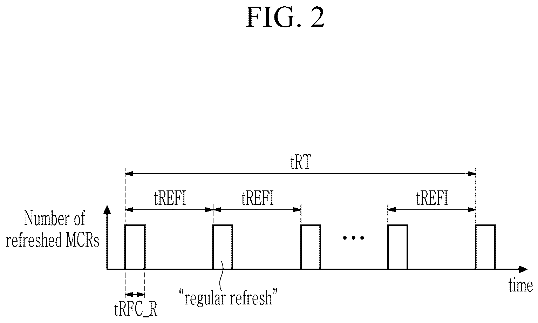

FIG. 2 is a diagram showing how a regular refresh operation is performed for one memory bank. Below, for a more concise explanation, a representative description is given of how a regular refresh operation is performed for the memory bank 140 with reference to FIGS. 1 and 2. The horizontal axis of FIG. 2 may represent time, and the vertical axis may represent the number of memory cell rows MCR that the memory device 100 refreshes per unit time.

The memory device 100 may perform a regular refresh operation during a regular refresh consumption time tRFC_R in response to the regular refresh command REF_R. For example, the memory device 100 may refresh some of the plurality of memory cells included in the memory bank 140 in response to the regular refresh command REF_R. Therefore, in order to refresh all memory cells included in the memory bank 140, the memory device 100 may have to perform the regular refresh operation a plurality of times.

In embodiments, during the regular refresh consumption time tRFC_R for the memory bank 140, the host device 10 may not be able to access the memory bank 140. For example, during the regular refresh consumption time tRFC_R for the memory bank 140, issuing other commands to the memory bank 140 of the host device 10 may be prohibited. In other words, due to the regular refresh consumption time tRFC_R for the memory bank 140, the input/output operation for the memory bank 140 may be limited (e.g., restricted), and thus the input/output performance of the memory device 100 may be degraded.

The time during which the integrity of data stored in a memory cell is guaranteed without a refresh operation may be referred to as a retention time tRT. To ensure the integrity of data stored in all memory cells of the memory bank 140, each memory cell must be refreshed at least once within the retention time tRT.

In embodiments, the memory device 100 may refresh different combinations of memory cell rows MCR whenever it performs a regular refresh operation within one retention time tRT. For example, the command issuance circuit 11 may issue the first and second regular refresh commands for the memory bank 140 within one retention time tRT. In this case, the memory device 100 may refresh a first plurality of memory cell rows in response to the first regular refresh command, and may refresh the second plurality of memory cell rows that are different from the first plurality of memory cell rows in response to the second regular refresh command.

To ensure the integrity of data stored in all memory cells of the memory bank 140, the command issuance circuit 11 should issue a predetermined number of regular refresh commands REF_R during the retention time tRT. For example, the command issuance circuit 11 should issue the regular refresh command REF_R 8192 times during a single retention time tRT. However, the scope of the present disclosure is not limited to the number of regular refresh commands REF_R should be issued by the command issuance circuit 11 during the single retention time tRT.

To issue the predetermined number of regular refresh commands REF_R during the single retention time tRT, the command issuance circuit 11 may issue a regular refresh command REF_R at each regular refresh period. That is, the command issuance circuit 11 may issue a regular refresh command REF_R every time a time length corresponding to a regular refresh interval tREFI elapses.

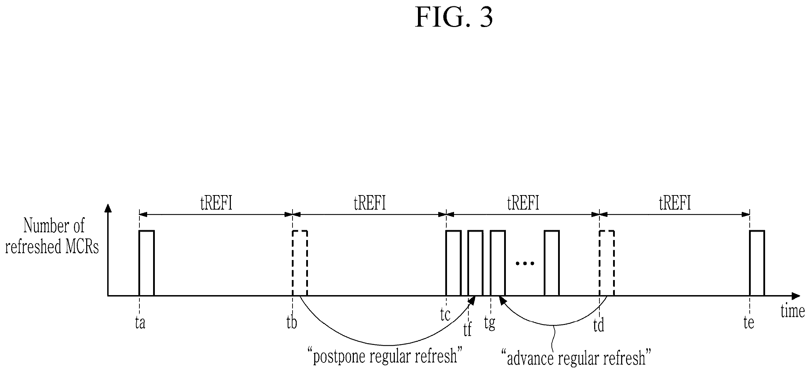

FIG. 3 is a diagram showing the operation of the refresh scheduling circuit of FIG. 1. Hereinafter, for a more concise explanation, embodiments of adjusting the timing at which a refresh scheduling circuit 14 issues the regular refresh command REF_R to the memory bank 140 of the command issuance circuit 11 is representatively described with reference to FIGS. 1 to 3. The horizontal axis of FIG. 3 may represent time, and the vertical axis may represent the number of memory cell rows MCR that the memory device 100 refreshes per unit time.

Referring to FIGS. 1 to 3, a regular refresh period may begin each at a first time point ta, a second time point tb, a third time point tc, a fourth time point td, and a fifth time point te. In this case, as described above with reference to FIG. 2, the command issuance circuit 11 may have to issue a regular refresh command REF_R at each of the first time point ta, the second time point tb, the third time point tc, the fourth time point td, and the fifth time point te in principle.

The refresh scheduling circuit 14 may pull-in (e.g., advance) or postpone the issuance of the regular refresh command REF_R of the command issuance circuit 11 a predetermined number of times. For example, instead of issuing the regular refresh command REF_R at the second time point tb, the command issuance circuit 11 may issue the regular refresh command REF_R at the sixth time point tf between the third time point tc and the fourth time point td. That is, the host device 10 may postpone issuing a regular refresh command REF_R for the second time point tb to the sixth time point tf. Conversely, instead of issuing a regular refresh command REF_R at the fourth time point td, the host device 10 may issue a regular refresh command REF_R at the seventh time point tg between the third time point tc and the fourth time point td. That is, the host device 10 may pull-in the issuance of the regular refresh command REF_R for the fourth time point td to the seventh time point tg. In this case, since the timing at which the command issuance circuit 11 issues a regular refresh command REF_R to the memory bank 140 may be flexibly adjusted, the operating efficiency of the memory system MS may be improved.

In embodiments, the number of times the command issuance circuit 11 may advance or postpone issuing a regular refresh command REF_R to the memory bank 140 may be referred to as a 'refresh fluctuation threshold'.

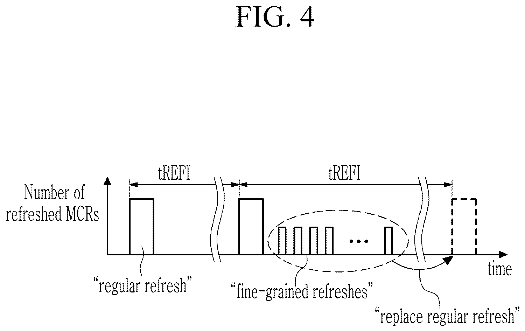

FIG. 4 is a diagram showing the operation of the refresh scheduling circuit of FIG. 1. Below, for a more concise explanation, the operation of the refresh scheduling circuit 14 when a fine-grained refresh operation is performed for the memory bank 140 is representatively described with reference to FIGS. 1 to 4. The horizontal axis of FIG. 4 may represent time, and the vertical axis may represent the number of memory cell rows MCR that the memory device 100 refreshes per unit time.

The command issuance circuit 11 may issue the plurality of fine-grained refresh commands REF_F for the memory bank 140 within one regular refresh interval tREFI. The memory device 100 may perform a fine-grained refresh operation in response to each of the plurality of fine-grained refresh commands REF_F.

In embodiments, the memory device 100 may refresh different combinations of memory cell rows MCR each time it performs the fine-grained refresh operation within one regular refresh interval tREFI. For example, the command issuance circuit 11 may issue a first fine-grained refresh command and a second fine-grained refresh command within one regular refresh interval tREFI. In this case, the memory device 100 may refresh a first group of memory cell rows in response to the first fine-grained refresh command, and may refresh a second group of memory cell rows that do not overlap with the first group in response to the second fine-grained refresh command.

A number of memory cell rows MCR refreshed when the memory device 100 performs one fine-grained refresh operation may be less than a number of memory cell rows refreshed when the memory device 100 performs one regular refresh operation. Accordingly, the memory device 100 may perform the fine-grained refresh operation a plurality of times to refresh the memory cell rows MCR corresponding to one regular refresh operation. In this way, the memory device 100 may replace the regular refresh operation with a plurality of fine-grained refresh operations. For example, the memory device 100 may perform fine-grained refresh operations a plurality of times to pre-refresh memory cell rows that are to be refreshed by regular refresh operations. However, the scope of the present disclosure is not limited thereto, and the memory device 100 may perform the fine-grained refresh operation with plurality of times to refresh memory cell rows that should have been refreshed by the regular refresh operation but were not refreshed due to skipping issuance of the regular refresh command REF_R. In other words, the refresh scheduling circuit 14 may replace issuing the regular refresh command REF_R with issuing the plurality of fine-grained refresh commands REF_F.

That is, according to embodiments of the present disclosure, the regular refresh operation may be replaced with a plurality of fine-grained refresh operations performed with shorter time units. In this case, a deterioration of input/output performance of the memory device 100 due to the regular refresh consumption time tRFC_R may be prevented. Therefore, according to the embodiment of the present disclosure, the operating efficiency and operating performance of the memory system MS may be improved.

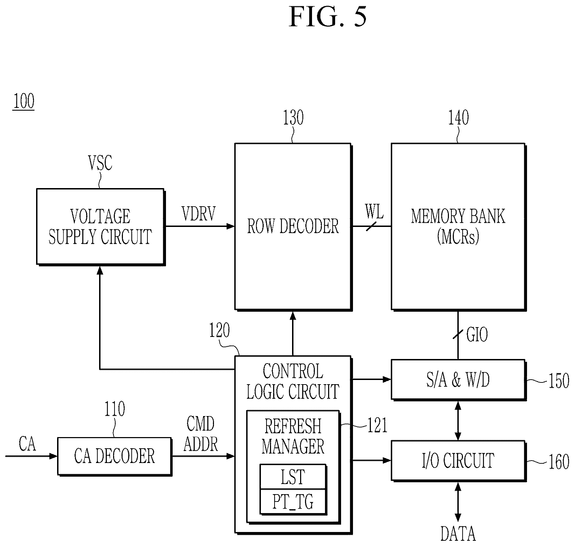

FIG. 5 is a block diagram showing the memory device of FIG. 1 in more detail. Referring to FIGS. 1 to 5, the memory device 100 may include a command/address decoder 110, a control logic circuit 120, a row decoder 130, a memory bank 140, a sense amplifier & write driver 150, an input/output circuit 160, and a voltage supply circuit VSC.

The command/address decoder 110 may receive command/address signals CA provided from the host device 10. The command/address decoder 110 may decode command/address signals CA into command CMD and address ADDR. That is, the command/address decoder 110 may receive command CMD and address ADDR from the host device 10 in the form of command/address signals CA.

The control logic circuit 120 may receive the command CMD and the address ADDR. The control logic circuit 120 may control overall operations of the memory device 100 based on the command CMD and the address ADDR. For example, the control logic circuit 120 may control the operation of the row decoder 130, the sense amplifier & write driver 150, the input/output circuit 160, and the voltage supply circuit VSC based on the command CMD and the address ADDR.

The row decoder 130 may be connected to the memory bank 140 through a plurality of wordlines WL. The row decoder 130 may control the plurality of wordlines WL in response to control of the control logic circuit 120. For example, the row decoder 130 may receive a driving voltage VDRV from a voltage supply circuit VSC in response to the control of the control logic circuit 120, and may activate some of the plurality of wordlines WL based on the driving voltage VDRV.

The memory bank 140 may be connected to a row decoder 130 via a plurality of wordlines WL and may be connected to a sense amplifier & write driver 150 via a plurality of global input/output lines GIO.

The memory bank 140 may include a plurality of memory cells arranged in a matrix form. Among the plurality of memory cells, memory cells connected to one wordline WL may be referenced as one memory cell row MCR. That is, memory cells connected to different wordlines WLs may be referenced as different memory cell rows MCRs.

In embodiments, each of the plurality of memory cells included in the memory bank 140 may be a dynamic random access memory (DRAM) cell, but the scope of the present disclosure is not limited thereto.

The sense amplifier & write driver 150 may be connected to the memory bank 140 with the plurality of global input/output lines GIO. The sense amplifier & write driver 150 may receive the data from the memory bank 140 through the plurality of global input/output lines GIO or store the data DATA in the memory bank 140 through the plurality of global input/output lines GIO in response to the control of the control logic circuit 120.

The input/output circuit 160 may communicate with the host device 10. For example, the input/output circuit 160 may provide the data DATA received from the host device 10 to the sense amplifier & write driver 150, or may transmit the data DATA provided from the sense amplifier & write driver 150 to the host device 10.

The control logic circuit 120 may include a refresh manager 121. The refresh manager 121 may manage a refresh target determination list LST and a refresh target pointer value PT_TG.

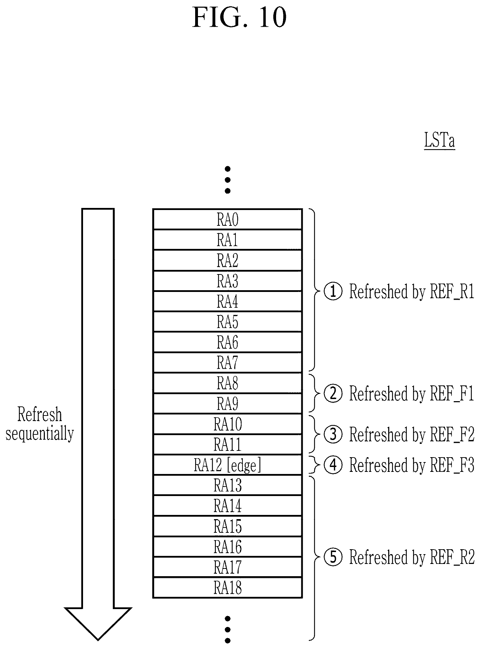

The refresh manager 121 may determine memory cell rows MCR to be refreshed in response to a regular refresh command REF_R and a fine-grained refresh command REF_F, based on the refresh target determination list LST and the refresh target pointer value PT_TG. The specific method how the refresh manager 121 determines the memory cell rows MCR to be refreshed is described in more detail with reference to FIGS. 10 to 13 below.

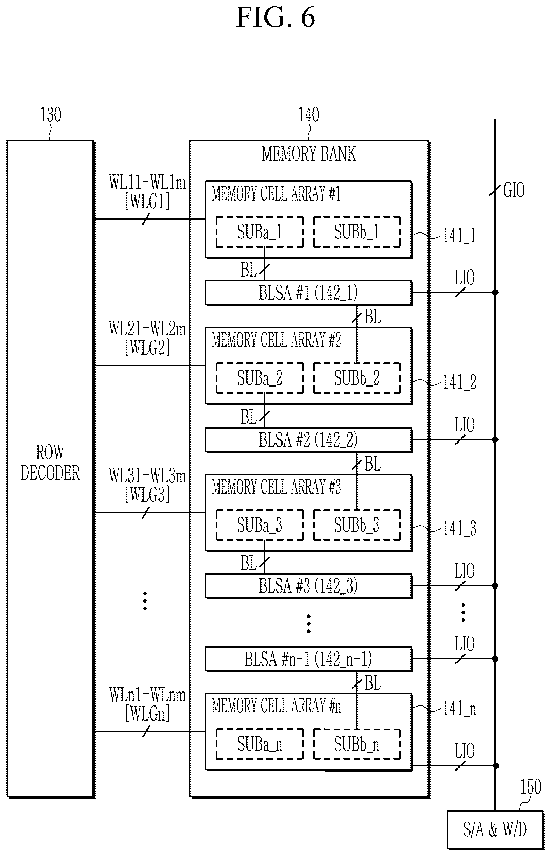

FIG. 6 is a drawing showing some configurations of FIG. 5 in more detail. Referring to FIGS. 1 to 6, the memory bank 140 may include first to n-th memory cell arrays 141_1 to 141_n and first to (n-1)-th bitline sense amplifiers 142_1 to 142_n-1. Each of the first to n-th memory cell arrays 141_1 to 141_n may include a plurality of memory cell rows MCR.

Each of the first to n-th memory cell arrays 141_1 to 141_n may be connected to a different wordline group WLG. For example, the first to n-th memory cell arrays 141_1 to 141_n may be connected to the first to n-th wordline groups WLG1 to WLGn, respectively. Each of the first to n-th wordline groups WLG1 to WLGn may exclusively include a plurality of wordlines WLs. That is, wordlines WL included in each of the first to n-th wordline groups WLG1 to WLGn may not overlap with each other. For example, a first wordline group WLG1 may include wordlines WL11 to WL1m, and a second wordline group WLG2 may include wordlines WL21 to WL2m.

Each of the first to n-th memory cell arrays 141_1 to 141_n may include a first sub-array SUBa and a second sub-array SUBb. For example, the first to n-th memory cell arrays 141_1 to 141_n may include first sub-arrays SUBa_1 to SUBa_n and second sub-arrays SUBb_1 to SUBb_n, respectively.

The first sub-array SUBa and the second sub-array SUBb included in same memory cell array 141 may be connected to same wordline group WLG. For example, both the first sub-array SUBa_1 and the second sub-array SUBb_1 may be connected to the wordlines WL11 to WL1m.

Each memory cell row MCR included in the memory bank 140 may include a plurality of memory cells connected to different bitlines. In this case, regarding to a plurality of memory cells of one memory cell row MCR, some of them may be included in the first sub-array SUBa and the remainders may be included in the second sub-array SUBb.

The first sub-array SUBa and the second sub-array SUBb included in same memory cell array 141 may be connected to different bitline groups. For example, the first sub-array SUBa may be connected to odd bitlines, and the second sub-array SUBa may be connected to even bitlines. However, the scope of the present disclosure is not limited thereto.

Each of the first to n-th memory cell arrays 141_1 to 141_n may be connected to one or more bitline sense amplifiers 142. For example, the first sub-arrays SUBa_1 to SUBa_n-1 may be respectively connected to the first to (n-1)-th bitline sense amplifiers 142_1 to 142_n-1 through a plurality of bitlines BL, and the second sub-arrays SUBb_2 to SUBb_n may be respectively connected to the first to (n-1)-th bitline sense amplifiers 142_1 to 142_n-1 through a plurality of bitlines BL.

Each of the first and n-th memory cell arrays 141_1, 141_n may be referred to as an 'edge memory cell array'. That is, each of the first and n-th memory cell arrays 141_1, 141_n may be referred to as having an 'edge memory cell array type'. Each of the edge memory cell arrays may be connected to one bitline sense amplifier 142.

In embodiments, the edge memory cell array may be referred to by various terms, such as an external memory cell array, an outer memory cell array, and the like. However, the scope of the present disclosure is not limited to these terms.

In embodiments, the first sub-array SUBa_n and the second sub-array SUBb_1 may not be connected to any bitline sense amplifier.

The second to (n-1)-th memory cell arrays 141_2 to 141_n-1 may be placed between the first and n-th memory cell arrays 141_1, 141_n. Each of the second to (n-1)-th memory cell arrays 141_2 to 141_n-1 may be referred to as an 'internal memory cell array'. That is, each of the second to (n-1)-th memory cell arrays 141_2 to 141_n-1 may be referred to as having an 'internal memory cell array type'. Each of the internal memory cell arrays may be connected to two bitline sense amplifiers 142.

In embodiments, the internal memory cell array may be referred to by various terms, such as a normal memory cell array, an inner memory cell array, a non-edge memory cell array, and the like. However, the scope of the present disclosure is not limited to these terms.

When a wordline WL connected to an internal memory cell array is activated, the first sub-array SUBa and the second sub-array SUBb included in the internal memory cell array may provide data to different bitline sense amplifiers 142 each other. For example, when a wordline WL21 is activated, data stored in memory cells which are included in the first sub-array SUBa_2 and connected to the wordline WL21 may be provided to the second bitline sense amplifier 142_2, and data stored in memory cells which are included in the second sub-array SUBb_2 and connected to the wordline WL21 may be provided to the first bitline sense amplifier 142_1. That is, when a wordline WL connected to an internal memory cell array is activated, data stored in a memory cell row MCR connected to the wordline WL may be distributed to two bitline sense amplifiers 142.

When a wordline WL connected to an edge memory cell array is activated, only one of the first sub-array SUBa and the second sub-array SUBb included in the edge memory cell array may provide data to bitline sense amplifier 142. For example, when a wordline WL11 is activated, data stored in memory cells which are included in the first sub-array SUBa_1 and connected to the wordline WL11 may be provided to the first bitline sense amplifier 142_1. On the other hand, when a wordline WLn1 is activated, data stored in memory cells which are included in the second sub-array SUBb_n and connected to the wordline WLn1 may be provided to the (n-1)-th bitline sense amplifier 142_n-1. That is, when a wordline WL connected to an edge memory cell array is activated, only some (e.g., half) of the data stored in the memory cell row MCR connected to the wordline WL may be provided to bitline sense amplifier 142.

In embodiments, data stored in memory cells included in the first sub-array SUBa_n of the second sub-array SUBb_1 may be dummy data. For example, the second sub-array SUBb_1 and the first sub-array SUBa_n may store invalid data. From this perspective, a subarray storing invalid data may also be referred to as an invalid subarray. However, the scope of the present disclosure is not limited thereto.

Each of the first to (n-1)-th bitline sense amplifiers 142_1 to 142_n-1 may temporarily store data received through the plurality of bitlines BL. Each of the first to (n-1)-th bitline sense amplifiers 142_1 to 142_n-1 may restore temporarily stored data to memory cells connected to an activated wordline WL. For example, when a wordline WL21 is activated, the second bitline sense amplifier 142_2 may temporarily store data stored in the first sub-array SUBa_2 and then restore the temporarily stored data to the first sub-array SUBa_2; and the first bitline sense amplifier 142_1 may temporarily store data stored in the second sub-array SUBb_2 and then restore the temporarily stored data to the second sub-array SUBb_2. In this way, when a specific wordline WL is activated, the memory cell row connected to the activated wordline WL may be refreshed.

The first memory cell array 141_1 and the n-th memory cell array 141_n may be logically combined (e.g., paired). For example, the first memory cell array 141_1 and the n-th memory cell array 141_n may share row address (hereinafter, referred to as "RA"). For example, when an activation command ACT corresponding one row address RA for an edge memory cell array is issued from the host device 10, the control logic circuit 120 may simultaneously activate one wordline WL connected to the first memory cell array 141_1 and one wordline WL connected to the n-th memory cell array 141_n. In this case, data of the first sub-array SUBa_1 may be provided to the first bitline sense amplifier 142_1, and data of the second sub-array SUBb_n may be provided to the (n-1)-th bitline sense amplifier 142_n-1.

In embodiments, a set of row addresses RA corresponding to the first wordline group WLG1 may be same as a set of row addresses RA corresponding to the n-th wordline group WLGn. For example, row addresses RA corresponding to the wordlines WL11 to WL1m may be identical to row addresses RA corresponding to the wordlines WLn1 to WLnm, respectively. However, the scope of the present disclosure is not limited thereto.

That is, when an activation command for a row address RA corresponding to the edge memory cell array is issued from the host device 10, two wordlines may be activated simultaneously. In other words, even in a typical situation where the host device 10 accesses a memory bank 140 (e.g., when memory device 100 perform normal operation), two wordlines WL may be activated simultaneously. A maximum number of wordlines WLs that may be simultaneously activated in a typical situation where the host device 10 accesses the memory bank 140 may be referred to as the 'maximum number of concurrently active wordlines for activation command' or 'maximum number of concurrently active wordlines'.

In embodiments, the maximum number of concurrently active wordlines for the memory bank 140 may be '2'. However, the scope of the present disclosure is not limited thereto.

Accordingly, even in a typical situation where the host device 10 accesses the memory bank 140, the voltage supply circuit VSC may guarantee power for simultaneously activating as many wordlines as the 'maximum number of simultaneously active wordlines'. According to embodiments of the present disclosure, in response to a fine-grained refresh command REF_F, a fine-grained refresh operation for a number of memory cell rows MCR less than or equal to the 'maximum number of concurrently active wordlines' may be performed simultaneously. In this case, an overhead of a voltage supply circuit VSC for providing the driving voltage VDRV to one or more wordlines WL while performing the fine-grained refresh operation may be minimized. In this case, the time taken by the voltage supply circuit VSC to generate the driving voltage VDRV may be minimized, and the memory device 100 may perform the fine-grained refresh operation with a shorter time than the regular refresh consumption time tRFC_R.

Each of the first to (n-1)-th bitline sense amplifiers 142_1 to 142_n-1 may be connected to a plurality of global input/output lines GIO through a plurality of local input/output lines LIO. Each of the first to (n-1)-th bitline sense amplifiers 142_1 to 142_n-1 may control voltage levels of the plurality of local input/output lines LIO based on voltage levels of bitlines BL connected thereto. Also, each of the first to (n-1)-th bitline sense amplifiers 142_1 to 142_n-1 may control voltage levels of bitlines BL based on voltage levels of the local input/output lines LIO.

The sense amplifier & write driver 150 may be connected to the plurality of global input/output lines GIO. The sense amplifier & write driver 150 may provide a data represented by the voltage levels of the plurality of global input/output lines GIO to the input/output circuit 160, or control the voltage levels of the plurality of global input/output lines GIO based on the data provided from the input/output circuit 160.

For brief description, FIG. 6 shows the plurality of local input/output lines LIO and the plurality of global input/output lines GIO as being directly connected, but the scope of the present disclosure is not limited thereto. For example, various types of components, such as a local sense amplifier, may be further connected between the plurality of local input/output lines LIO and the plurality of global input/output lines GIO.

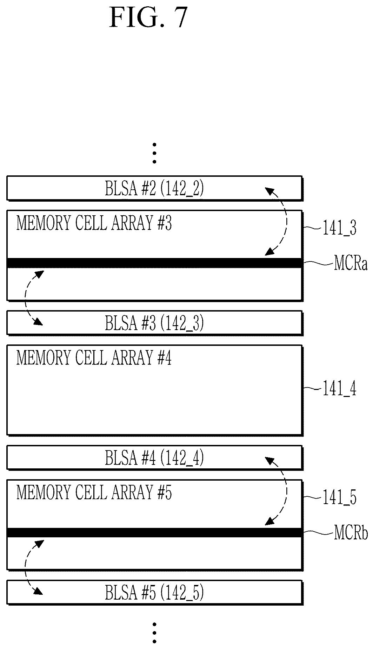

FIG. 7 is a diagram showing in more detail how the refresh operation is performed. Referring to FIGS. 1 to 7, the control logic circuit 120 may perform a refresh operation for one or more memory cell rows MCR, in response to the regular refresh command REF_R or the fine-grained refresh command REF_F. For example, the control logic circuit 120 may perform refresh operation for about eight (e.g., eight to ten) memory cell rows MCR in response to the regular refresh command REF_R, and may perform refresh operation on one or two memory cell rows MCR in response to the fine-grained refresh command REF_F. However, the scope of the present disclosure is not limited to the specific number of memory cell rows MCR that the control logic circuit 120 refreshes in response to the regular refresh command REF_R or the fine-grained refresh command REF_F.

The control logic circuit 120 may perform refresh operation on two or more memory cell rows MCR simultaneously. For example, the control logic circuit 120 may simultaneously refresh eight memory cell rows MCR in response to a single regular refresh command REF_R and may simultaneously refresh two memory cell rows MCR in response to a single fine-grained refresh command REF_F. However, the scope of the present disclosure is not limited thereto, and the control logic circuit 120 may be implemented to refresh total of eight memory cell rows MCR by refreshing the four memory cell rows MCR with two cycles, or may be implemented to refresh a total of eight memory cell rows MCR by refreshing the two memory cell rows MCR with four cycles.

More specifically, the control logic circuit 120 may refresh one memory cell row MCR for each of a plurality of memory cell arrays 141 which are not adjacent each other. For example, the control logic circuit 120 may activate a wordline connected to a first memory cell row MCRa included in the third memory cell array 141_3. In this case, data stored in the first memory cell row MCRa may be temporarily stored in the second bitline sense amplifier 142_2 and the third bitline sense amplifier 142_3 and then be restored. At the same time, the control logic circuit 120 may activate the wordline connected to a second memory cell row MCRb included in the fifth memory cell array 141_5. In this case, data stored in the second memory cell row MCRb may be temporarily stored in the fourth bitline sense amplifier 142_4 and the fifth bitline sense amplifier 142_5 and then be restored. In this way, the control logic circuit 120 may refresh two or more memory cell rows MCR simultaneously. For a more concise explanation, only the third to fifth memory cell arrays 141_3 to 141_5 are illustrated in FIG. 7, but the scope of the present disclosure is not limited thereto. For example, the control logic circuit 120 may simultaneously refresh two or more memory cell rows MCR in response to the regular refresh command REF_R; or may simultaneously refresh two memory cell rows MCR respectively included in two edge memory cell arrays in response to the fine-grained refresh command REF_F.

In embodiments, the plurality of memory cell arrays 141 which are not adjacent each other may not share bitline sense amplifiers with each other. For example, one or more memory cell arrays may be included between the plurality of memory cell arrays 141 which are not adjacent each other.

In embodiments, as a number of memory cell rows MCR that the control logic circuit 120 refreshes simultaneously increases, an amount of power required to provide the driving voltage VDRV to the wordlines WL connected to the corresponding memory cell rows MCR may increase. In this case, the time taken by the voltage supply circuit VSC to prepare and provide the driving voltage VDRV to the wordlines WL connected to the corresponding memory cell rows MCR may increase. Therefore, depending on how many memory cell rows MCR the control logic circuit 120 refreshes simultaneously, the time taken for the control logic circuit 120 to complete the operations for the regular refresh command REF_R and the fine-grained refresh command REF_F may vary.

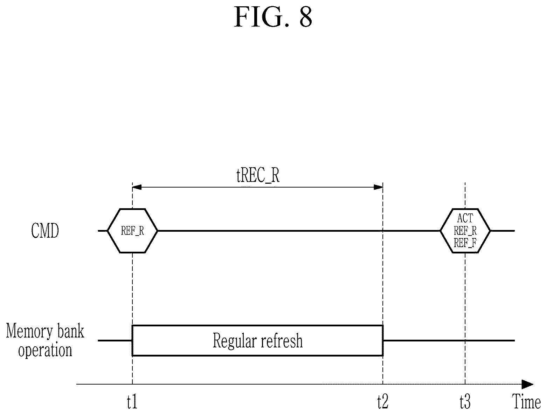

FIG. 8 is a timing diagram showing an operation of the memory device in response to the regular refresh command according to embodiments of the present disclosure. The horizontal axis of FIG. 8 may represent time.

Referring to FIGS. 1 to 8, the host device 10 may issue the regular refresh command REF_R to the memory bank 140 at a first time point t1. In this case, the control logic circuit 120 may perform a regular refresh operation for the memory bank 140 between the first time point t1 and the second time point t2. For example, the control logic circuit 120 may perform the refresh operation for about eight memory cell rows MCR included in the memory bank 140 between a first time point t1 and a second time point t2.

The time required for the control logic circuit 120 to complete the regular refresh operation for the memory bank 140 may be referred to as a regular refresh consumption time tRFC_R. For example, a time interval between the first time point t1 and the second time point t2 may be referred to as the regular refresh consumption time tRFC_R.

The host device 10 may issue a subsequent command to the memory bank 140 after the regular refresh consumption time tRFC_R has elapsed from the first time point t1. For example, the host device 10 may issue an activation command ACT, a regular refresh command REF_R, or a fine-grained refresh command REF_F to the memory bank 140 at a third time point t3 after the second time point t2.

In embodiments, 'an activation command ACT for the memory bank 140' may refer to an activation command corresponding to a bank address for the memory bank 140.

In embodiments, 'a fine-grained refresh command REF_F for the memory bank 140' may refer to a fine-grained refresh command corresponding to a bank address for the memory bank 140.

In embodiments, 'a regular refresh command REF_R for the memory bank 140' may refer to an all-bank refresh command, or a per-bank refresh command for the memory bank 140. However, the scope of the present disclosure is not limited to these examples.

In embodiments, access to the memory bank 140 of the host device 10 may be prohibited during the regular refresh consumption time tRFC_R. For example, the host device 10 may not issue an activation command ACT to the memory bank 140 between the first time point t1 and the second time point t2.

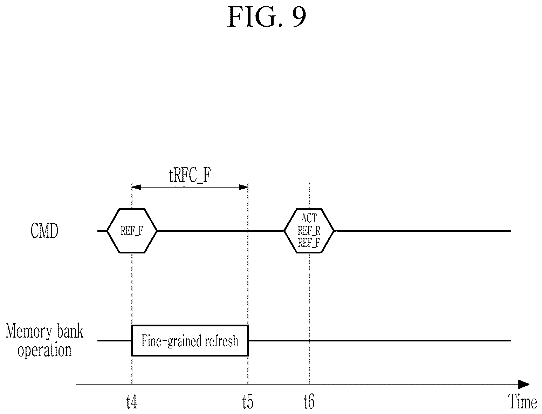

FIG. 9 is a timing diagram showing an operation of the memory device in response to a fine-grained refresh command according to embodiments of the present disclosure. The horizontal axis of FIG. 9 may represent time.

Referring to FIGS. 1 to 9, the host device 10 may issue a fine-grained refresh command REF_F to the memory bank 140 at a fourth time point t4. In this case, the control logic circuit 120 may perform the fine-grained refresh operation for the memory bank 140 between the fourth time point t4 and a fifth time point t5. For example, the control logic circuit 120 may perform a refresh operation on one or two memory cell rows MCR included in the memory bank 140 between the fourth time point t4 and the fifth time point t5.

The time required for the control logic circuit 120 to complete a fine-grained refresh operation for the memory bank 140 may be referred to as a fine-grained refresh consumption time tRFC_F. For example, a time interval between the fourth time point t4 and the fifth time point t5 may be referred to as the fine-grained refresh consumption time tRFC_F.

The host device 10 may issue a subsequent command to the memory bank 140 after the fine-grained refresh consumption time tRFC_F has elapsed from the fourth time point t4. For example, the host device 10 may issue an activation command ACT, a regular refresh command REF_R, or a fine-grained refresh command REF_F to the memory bank 140 at a sixth time point t6 after the fifth time point t5.

The fine-grained refresh consumption time tRFC_F may be shorter than the regular refresh consumption time tRFC_R. For example, the fine-grained refresh consumption time tRFC_F may be a time length corresponding to a same bank activation minimum interval (hereinafter referred to as "tRC") for the memory bank 140, and the regular refresh consumption time tRFC_R may be a time length longer than the same bank activation minimum interval tRC for the memory bank 140.

In embodiments, the fine-grained refresh consumption time tRFC_F may have same length as the same bank activation minimum interval tRC. However, the scope of the present disclosure is not limited thereto, and the fine-grained refresh consumption time tRFC_F may have a length similar to the same bank activation minimum interval tRC.

In embodiments, the regular refresh consumption time tRFC_R may be at least twice the same bank activation minimum interval tRC for the memory bank 140. However, the scope of the present disclosure is not limited thereto.

In embodiments, the fine-grained refresh consumption time tRFC_F may be about 60ns. However, the scope of the present disclosure is not limited thereto.

In embodiments, the regular refresh consumption time tRFC_R may be 120ns to 400ns. However, the scope of the present disclosure is not limited thereto.

In embodiments, access to the memory bank 140 of the host device 10 may be prohibited during the fine-grained refresh consumption time tRFC_F. For example, the host device 10 may not issue an activation command ACT to the memory bank 140 between the fourth time point t4 and the fifth time point t5.

That is, a time length where the access to the memory bank 140 is prohibited when the host device 10 issues the fine-grained refresh command REF_F may be shorter than a time length where the access to the memory bank 140 is prohibited when the host device 10 issues the regular refresh command REF_R.

In embodiments, the fourth time point t4 may be a time point after the third time point t3. Alternatively, the sixth time point t6 may be a time point before the first time point t1. In other words, the host device 10 may flexibly issue the regular refresh command REF_R and the fine-grained refresh command REF_F to one memory bank 140. In this case, the command issuance schedule of the host device 10 may be determined more flexibly, so the operating efficiency of the memory system MS may be improved.

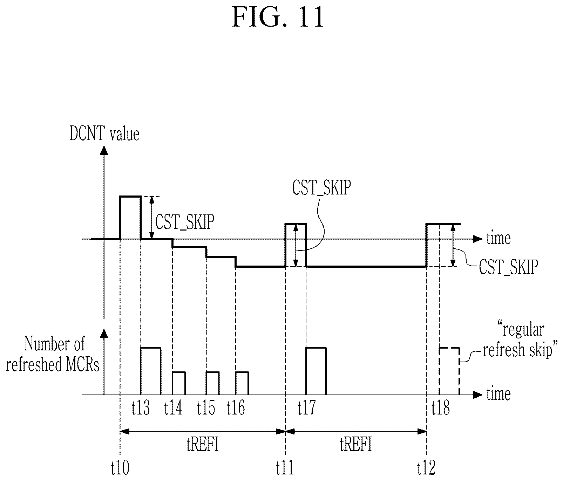

FIGS. 10 and 11 are drawings showing the operation of the memory system according to embodiments. Hereinafter, the operation of a memory device 100 according to embodiments will be described with reference to FIG. 10, and the operation of a host device 10 according to embodiments will be described with reference to FIG. 11.

First, referring to FIGS. 1 to 10, the refresh target determination list LST may be implemented as the following refresh target determination list LSTa.

The refresh target determination list LSTa may include a plurality of row addresses RAs arranged sequentially. For example, the refresh target determination list LSTa may include the 0-th to eighteenth row addresses RA0 to RA18. The 0-th to eighteenth row addresses RA0 to RA18 may have different orders (e.g., have different rank or order index).

The refresh manager 121 may perform a refresh operation for the plurality of row addresses RA in response to a regular refresh command REF_R provided from the host device 10. For example, the refresh manager 121 may perform a refresh operation for eight row addresses RA in response to the regular refresh command REF_R. However, the scope of the present disclosure is not limited to the specific number of row addresses RA corresponding to memory cell rows MCR refreshed by the refresh manager 121 in response to the regular refresh command REF_R. For example, the refresh manager 121 may perform a refresh operation for any number of row addresses RA, such as 4, 16, or 32, in response to a regular refresh command REF_R. However, below, it is assumed that the refresh manager 121 performs a refresh operation for eight row addresses RA in response to the regular refresh command REF_R.

The refresh manager 121 may perform a refresh operation for one or more row addresses RA in response to a fine-grained refresh command REF_F provided from the host device 10. For example, the refresh manager 121 may perform a refresh operation for one or two row addresses RA in response to the fine-grained refresh command REF_F.

The refresh manager 121 may sequentially perform refresh operations for the plurality of row addresses RA included in the refresh target determination list LSTa, in response to the regular refresh command REF_R and the fine-grained refresh command REF_F. For example, based on the refresh target determination list LSTa and the refresh target pointer value PT_TG, the refresh manager 121 may determine which row addresses RA the refresh operation is performed for (hereinafter, the row addresses may be referred to as refresh target row addresses RA_TG), in response to the regular refresh command REF_R or the fine-grained refresh command REF_F.

In embodiments, refresh target row addresses RA_TG corresponding to the regular refresh command REF_R may be referred to as 'regular refresh target row addresses'.

In embodiments, the refresh target row addresses RA_TG corresponding to the fine-grained refresh command REF_F may be referred to as 'fine-grained refresh target row addresses'.

Hereinafter, an operation of the refresh manager 121 is exemplarily described when a first regular refresh command REF_R1, first to third fine-grained refresh commands REF_F1 to REF_F3, and second regular refresh command REF_R2 are sequentially received from the host device 10 in a state where the refresh target pointer value PT_TG indicates the 0-th row address RA0 (for example, a state where the refresh target pointer value PT_TG is '0'). However, the scope of the present disclosure is not limited thereto.

The refresh manager 121 may determine the refresh target row addresses RA_TG for the first regular refresh command REF_R1 based on the refresh target pointer value PT_TG. For example, the refresh manager 121 may determine a total of eight row addresses RA having a continuous order (e.g., sequential order in the refresh target determination list LSTa) from a row address indicated by the refresh target pointer value PT_TG (hereinafter, the row address indicated by the refresh target pointer value PT_TG may be referred to as a pointed row address RA_PTD) as refresh target row addresses RA_TG. For a more detailed example, the refresh manager 121 may determine the 0-th to seventh row addresses RA0 to RA7 as refresh target row addresses RA_TG for the first regular refresh command REF_R1. The refresh manager 121 may perform refresh operation for the refresh target row addresses RA_TG.

A number of memory cell rows MCR refreshed by the refresh manager 121 in response to the regular refresh command REF_R may vary depending on the type of memory cell array corresponding to each of the refresh target row addresses RA_TG. For example, if each of the 0-th to seventh row addresses RA0 to RA7 corresponds to the internal memory cell array described above with reference to FIG. 6, the refresh manager 121 may perform a refresh operation for a total of eight memory cell rows MCR. On the other hand, if some of the 0-th to seventh row addresses RA0 to RA7 correspond to the edge memory cell array described above with reference to FIG. 6, the refresh manager 121 may perform refresh operation for as many memory cell rows MCR as a sum of eight and a number of row addresses corresponding to the edge memory cell and array. For a more detailed example, if two of the 0-th to seventh row addresses RA0 to RA7 correspond to edge memory cell arrays, the refresh manager 121 may perform refresh operation for total of ten memory cell rows MCR.

In embodiments, a number of refresh target row addresses RA_TG corresponding to one regular refresh command REF_R may be referred to as 'a number of regular refresh targets'. However, the scope of the present disclosure is not limited to these terms.

After completing refresh operation corresponding to the refresh target row addresses RA_TG for the first regular refresh command REF_R1, the refresh manager 121 may increase the refresh target pointer value PT_TG by a number of row addresses RA which the refresh operation has been completed for. For example, the refresh manager 121 may increase the refresh target pointer value PT_TG by '8' (e.g., update it to point to an eighth row address RA8) after completing a regular refresh operation in response to the first regular refresh command REF_R1.

The refresh manager 121 may determine refresh target row addresses RA_TG for the fine-grained refresh command REF_F based on the updated refresh target pointer value PT_TG. For example, the refresh manager 121 may determine a number of refresh target row addresses RA_TG for the fine-grained refresh command REF_F based on a type of the memory cell array corresponding to the pointed row address RA_PTD and a subsequent row address thereto (e.g., a row address following right after the pointed row address RA_PTD in the refresh target determination list LSTa)(hereinafter, it may be referred to as a subsequent row address RA_SUBS).

In embodiments, a number of refresh target row addresses RA_TG corresponding to one fine-grained refresh command REF_F may be referred to as a 'number of fine-grained refresh targets'. However, the scope of the present disclosure is not limited to these terms.

More specifically, the refresh manager 121 may determine only the pointed row address RA_PTD as the refresh target row address RA_TG when at least one of the pointed row address RA_PTD and the subsequent row address RA_SUBS corresponds to the edge memory cell type (e.g., if at least one of the pointed row address RA_PTD and the subsequent row address RA_SUBS pointing a wordline connected to the edge memory cell array). More specifically, when the pointed row address RA_PTD corresponds to the edge memory cell type, the refresh manager 121 may perform refresh operation on two memory cell rows MCR corresponding to the pointed row address RA_PTD (for example, one memory cell row MCR included in the first memory cell array 141_1 and one memory cell row MCR included in the n-th memory cell array 141_n) and increase the refresh target pointer value PT_TG by '1'. When the pointed row address RA_PTD corresponds to an internal memory cell type and the subsequent row address RA_SUBS corresponds to an edge memory cell type, the refresh manager 121 may perform refresh operation for one memory cell row MCR corresponding to the pointed row address RA_PTD and increase the refresh target pointer value PT_TG by '1'.

On the other hand, when both of the pointed row address RA_PTD and the subsequent row address RA_SUBS indicated by the refresh target pointer value PT_TG correspond to the internal memory cell type (e.g., when each of the pointed row address RA_PTD and the subsequent row address RA_SUBS points wordline connected to an internal memory cell array), the refresh manager 121 may determine the pointed row address RA_PTD and the subsequent row address RA_SUBS as the refresh target row addresses RA_TG. In this case, the refresh manager 121 may perform refresh operation for two memory cell rows MCR respectively corresponding to the pointed row address RA_PTD and the subsequent row address RA_SUBS, and may increase the refresh target pointer value PT_TG by '2'.

In other words, a number of row addresses RA, of which the refresh manager 121 performs refresh operations in response to the fine-grained refresh command REF_F, may be determined based on the memory cell types corresponding to the pointed row address RA_PTD and the subsequent row address RA_SUBS.

In this way, the refresh manager 121 may determine the refresh target row addresses RA_TG for each of the first to third fine-grained refresh commands REF_F1 to REF_F3.

For example, each of the eighth and ninth row addresses RA8 to RA9 may correspond to an internal memory cell array. In this case, the refresh manager 121 may perform a refresh operation for the eighth to ninth row addresses RA8 to RA9 in response to the first fine-grained refresh command REF_F1 and then increase the refresh target pointer value PT_TG by '2' (i.e., update it to indicate the tenth row address RA10).

Each of the tenth to eleventh row addresses RA10 to RA11 may correspond to an internal memory cell array. In this case, the refresh manager 121 may perform a refresh operation for the tenth to eleventh row addresses RA10 to RA11 in response to the second fine-grained refresh command REF_F2, and then increase the refresh target pointer value PT_TG by '2' (i.e., update it to indicate the twelfth row address RA12).

One or more of the twelfth to thirteenth row addresses RA12 to RA13 may correspond to an edge memory cell array. For example, the twelfth row address RA12 may correspond to an edge memory cell array. In this case, the refresh manager 121 may perform a refresh operation for the twelfth row address RA12 in response to the third fine-grained refresh command REF_F3, and then increase the refresh target pointer value PT_TG by '1' (i.e., update it to indicate the thirteenth row address RA13).

Hereinafter, for a more concise explanation, a row address corresponding to the edge memory cell array may be referred to as an 'edge row address' (or, external row address, outer row address, etc.). A row address corresponding to an internal memory cell array may be referred to as an 'internal row address' (or, normal row address, inner row address, non-edge row address, etc.).

In embodiments, an edge row address may point to two memory cell rows, which are respectively corresponding to two edge memory cell array.

Thereafter, the refresh manager 121 may determine refresh target row addresses RA_TG for the second regular refresh command REF_R2 based on the updated refresh target pointer value PT_TG. For example, the refresh manager 121 may determine a total of eight row addresses RA having a continuous order starting from the pointed row address RA_PTD (e.g., the thirteenth row address RA13) as refresh target row addresses RA_TG.

In this way, the refresh manager 121 may perform refresh operation for each row address only once during one retention time tRT. In other words, according to the embodiment of FIG. 10, since over-refresh (e.g., too much refresh) for the memory bank 140 may be prevented, the operating efficiency of the memory device 100 may be improved and the power consumption of the memory device 100 may be reduced.

Continuing with further reference to FIG. 11, the host device 10 may flexibly issue the regular refresh command REF_R and the fine-grained refresh command REF_F based on the refresh debit count DCNT. The horizontal axis of FIG. 11 may represent time, and the vertical axis may represent a value of the refresh debit count DCNT or a number of memory cell rows MCR refreshed per unit time.

A regular refresh period for the memory bank 140 may occur at a tenth time point t10, an eleventh time point t11, and a twelfth time point t12. For example, regular refresh periods for the memory bank 140 may begin at the tenth time point t10, the eleventh time point t11, and the twelfth time point t12. For a more concise explanation, below, it is assumed that the refresh debit count DCNT for the memory bank 140 is '0' before the tenth time point t10.

The host device 10 may increase the refresh debit count DCNT by a skip cost CST_SKIP at every regular refresh period. For example, the host device 10 may increase the refresh debit count DCNT by the skip cost CST_SKIP at the tenth time point t10, the eleventh time point t11, and the twelfth time point t12.

The host device 10 may decrease the refresh debit count DCNT by the skip cost CST_SKIP whenever the host device 10 issues the regular refresh command REF_R. For example, at the thirteenth time point t13, the host device 10 may issue a first regular refresh command REF_R1 and decrease the refresh debit count DCNT to '0'.

The host device 10 may issue a plurality of fine-grained refresh commands REF_F between the tenth time point t10 and the eleventh time point t11. For example, the host device 10 may issue the first to third fine-grained refresh commands REF_F1 to REF_F3 at fourteenth to sixteenth time points t14 to t16, respectively.

The host device 10 may decrease the refresh debit count DCNT by the 'unit redemption cost (e.g., 1)' whenever the host device 10 issues the fine-grained refresh command REF_F. For example, the host device 10 may decrease the refresh debit count DCNT by '1' at each of the fourteenth to sixteenth time points t14 to t16.

The host device 10 may issue a second regular refresh command REF_R2 at a seventeenth time point t17. In this case, similarly to what was described above with reference to the thirteenth time point t13, the host device 10 may decrease the refresh debit count DCNT by the skip cost CST_SKIP at the seventeenth time point t17. That is, according to the embodiments of FIGS. 10 and 11, the host device 10 may decrease the refresh debit count DCNT by the skip cost CST_SKIP each time the host device 10 issues the regular refresh command REF_R.

Meanwhile, the host device 10 may determine whether to skip issuing a regular refresh command REF_R based on the refresh debit count DCNT. For example, the host device 10 may freely determine timing of issuing a regular refresh command REF_R (e.g., for skipping or delaying), similar to what was described above with reference to FIG. 4. That is, the host device 10 may maintain the refresh debit count DCNT does not go out of a predetermined refresh debit count range (e.g., to be in the predetermined refresh debit count range) at the regular refresh time point where the regular refresh periods begins, by flexibly issue the regular refresh command REF_R and the fine-grained refresh command REF_F. For a more detailed example, the host device 10 may skip issuing the regular refresh command REF_R at the eighteenth time point t18 and maintain the refresh debit count DCNT.

In embodiments, the predetermined refresh debit count range may correspond to a range, from a value less than '0' by a product of the 'refresh fluctuation threshold' and the skip cost CST_SKIP, to a value greater than '0' by a product of the 'refresh fluctuation threshold' and the skip cost CST_SKIP. In this case, a phenomenon of excessively performing refresh operations on the memory bank 140 and a phenomenon of insufficiently performing refresh on the memory bank 140 may be prevented. However, the scope of the present disclosure is not limited thereto.

In embodiments, the skip cost CST_SKIP may be determined based on a value obtained by dividing an average number of memory cell rows that the memory device 100 refreshes in response to the regular refresh command REF_R by an average number of memory cell rows that the memory device 100 refreshes in response to the fine-grained refresh command REF_F. For example, the skip cost CST_SKIP may be determined based on a result of rounding up the value obtained by dividing the average number of memory cell rows that the memory device 100 refreshes in response to the regular refresh command REF_R by the average number of memory cell rows that the memory device 100 refreshes in response to the fine-grained refresh command REF_F. For a more detailed example, if the average number of memory cell rows that the memory device 100 refreshes in response to the regular refresh command REF_R is '8.1' and the average number of memory cell rows that the memory device 100 refreshes in response to the fine-grained refresh command REF_F is 1.9, the skip cost CST_SKIP may be determined as '5 (e.g., a result of ceiling 8.1/1.9 to nearest integer)'. However, the scope of the present disclosure is not limited thereto, and the skip cost CST_SKIP may also be determined in decimal units. That is, the scope of the present disclosure is not limited to the data type (e.g., integer, floating point, fixed point, etc.) of the skip cost CST_SKIP.

In embodiments, the average number of memory cell rows that the memory device 100 refreshes in response to the regular refresh command REF_R may be determined as a product of a number of row addresses RA of which the memory device 100 performs refresh operation in response to the regular refresh command REF_R and $\frac{n+2}{n}$ (wherein 'n' is a total number of memory cell arrays included in the memory bank 140).

In embodiments, the average number of memory cell rows that the memory device 100 refreshes in response to the fine-grained refresh command REF_F may be determined as the maximum number of concurrently active wordlines for the activation command or less.

In embodiments, the average number of memory cell rows that the memory device 100 refreshes in response to the fine-grained refresh command REF_F may be determined according to an arrangement (e.g., ordering) of the plurality of row addresses RA included in the refresh target determination list LST.

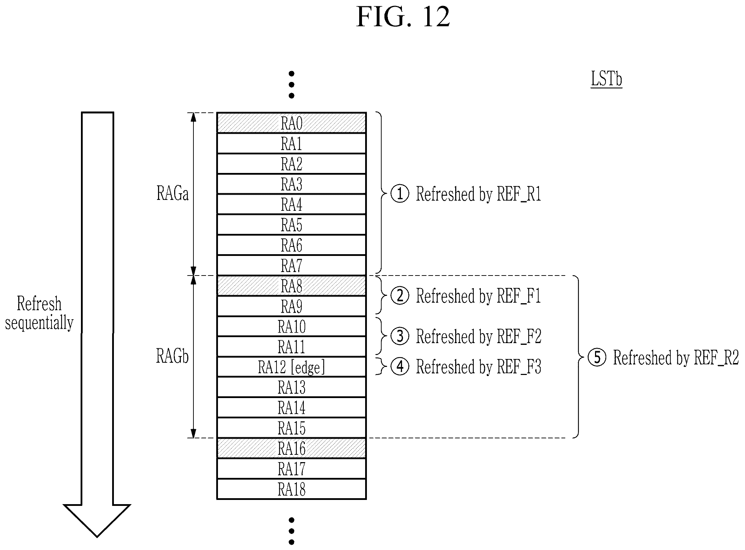

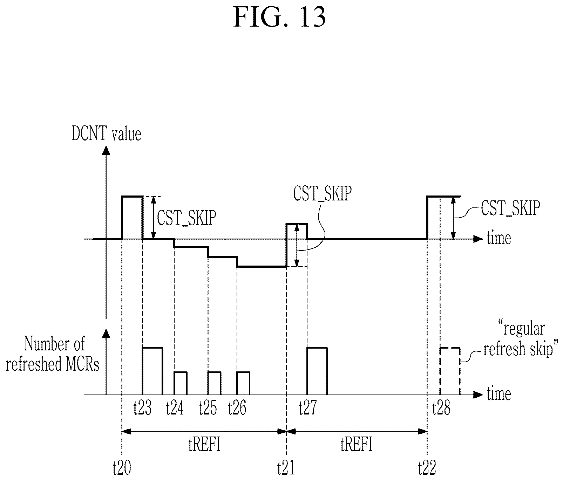

FIGS. 12 and 13 are diagrams showing an operation of the memory system according to embodiments. Hereinafter, the operation of the memory device 100 according to embodiments will be described with reference to FIG. 12, and an operation of the host device 10 according to embodiments will be described with reference to FIG. 13.

First, referring to FIGS. 1 to 9 and FIG. 12, the refresh target determination list LST may be implemented as the following refresh target determination list LSTb.

The refresh target determination list LSTb may include a plurality of row addresses RAs arranged sequentially. For example, the refresh target determination list LSTb may include the 0-th to eighteenth row addresses RA0 to RA18.

The refresh manager 121 may perform refresh operation for the plurality of row addresses RA in response to a regular refresh command REF_R provided from the host device 10. A number of memory cell rows MCR and row addresses RA refreshed by the refresh manager 121 in response to a regular refresh command REF_R is similar to that described above with reference to FIG. 10, so a detailed description is omitted.

The refresh manager 121 may perform refresh operation for one or more row addresses RA in response to the fine-grained refresh command REF_F provided from the host device 10. The operation of the refresh manager 121 in response to the fine-grained refresh command REF_F is similar to that described above with reference to FIG. 10, so a detailed description is omitted.

The refresh manager 121 may sequentially perform refresh operations for the plurality of row addresses RA included in the refresh target determination list LSTb in response to the regular refresh command REF_R and the fine-grained refresh command REF_F. For example, the refresh manager 121 may determine one or more target row addresses RA_TG for the regular refresh command REF_R and the fine-grained refresh command REF_F based on the refresh target determination list LSTb and the refresh target pointer value PT_TG.

The refresh target determination list LSTb may include a plurality of row address groups RAGs. Each of the plurality of row address groups RAGs may exclusively include a plurality of row addresses RAs which are sequentially ordered. That is, each of the plurality of row address groups RAGs may include a different subset of the plurality of row addresses RAs. In other words, the plurality of row addresses RAs included in the refresh target determination list LSTb may be classified into the plurality of row address groups RAGs.

Each of the plurality of row address groups RAGs may include same number of row addresses RAs. For example, each of the plurality of row address groups RAGs may include a number of row addresses same as a number of row addresses RAs of which refresh operation is performed in response to a single regular refresh command REF_R (e.g., eight). For a more detailed example, the 0-th to seventh row addresses RA0 to RA7 may be included in a first row address group RAGa, and the eighth to fifteenth row addresses RA8 to RA15 may be included in a second row address group RAGb.

A highest ordered row address among row addresses included in each of the plurality of row address groups RAGs may be referred to as a 'group head row address (which are illustrated as a stripe pattern)'. For example, the 0-th row address RA0 may be referenced as a group head row address for the first row address group RAGa, and the eighth row address RA8 may be referenced as a group head row address for the second row address group RAGb.

The refresh manager 121 may determine refresh target row addresses RA_TG for the fine-grained refresh command REF_F in a similar manner as described above with reference to FIG. 10. For example, the refresh manager 121 may determine one or two row addresses as the refresh target row addresses RA_TG based on the refresh target pointer value PT_TG.

The refresh manager 121 may determine refresh target row addresses RA_TG for the regular refresh command REF_R based on a unit of row address group RAG corresponding to the refresh target pointer value PT_TG. For example, the refresh manager 121 may determine all row addresses RA included in one row address group RAG as refresh target row addresses RA_TG in response to the regular refresh command REF_R.

Hereinafter, an operation of the refresh manager 121 is exemplarily described when a first regular refresh command REF_R1, first to third fine-grained refresh commands REF_F1 to REF_F3, and second regular refresh command REF_R2 are sequentially received from the host device 10, in a state where the refresh target pointer value PT_TG indicates the 0-th row address RA0 (for example, a state where the refresh target pointer value PT_TG is '0'). However, the scope of the present disclosure is not limited thereto.

The refresh manager 121 may determine refresh target row addresses RA_TG for the first regular refresh command REF_R1 based on the refresh target pointer value PT_TG. For example, the refresh manager 121 may determine all row addresses RA within a row address group RAG including the pointed row address RA_PTD as refresh target row addresses RA_TG. For a more detailed example, if the pointed row address RA_PTD is the 0-th row address RA0, the refresh manager 121 may determine the 0-th to seventh row addresses RA0 to RA7 as refresh target row addresses RA_TG for the first regular refresh command REF_R1.

After completing refresh operation corresponding to the refresh target row addresses RA_TG for the first regular refresh command REF_R1, the refresh manager 121 may update the refresh target pointer value PT_TG to point a group head row address of next row address group RAG. For example, the refresh manager 121 may increase the refresh target pointer value PT_TG by '8' so that the refresh target pointer value PT_TG points to the eighth row address RA8 (which is group head row address of the second row address group RAGb).

The refresh manager 121 may determine refresh target row addresses RA_TG for each of the first to third fine-grained refresh commands REF_F1 to REF_F3. The refresh manager 121 may update the refresh target pointer value PT_TG after completing a fine-grained refresh operation for each of the first to third fine-grained refresh commands REF_F1 to REF_F3. In this case, after the fine-grained refresh operation for the third fine-grained refresh command REF_F3 is completed, the refresh target pointer value PT_TG may point to the thirteenth row address RA13. The operation of the refresh manager 121 in response to the first to third fine-grained refresh commands REF_F1 to REF_F3 is similar to that described above with reference to FIG. 10, and therefore, a detailed description is omitted.

Thereafter, the refresh manager 121 may determine refresh target row addresses RA_TG for the second regular refresh command REF_R2 based on the refresh target pointer value PT_TG. For example, the refresh manager 121 may determine all row addresses RA included in the second row address group RAGb, which includes the pointed row address RA_PTD (i.e., the thirteenth row address RA13), as the refresh target row addresses RA_TG. For a more detailed example, the refresh manager 121 may determine the eighth to fifteenth row addresses RA8 to RA15 as refresh target row addresses RA_TG for the second regular refresh command REF_R2.

After the regular refresh operation for the second regular refresh command REF_R2 is completed, the refresh manager 121 may update the refresh target pointer value PT_TG to point a group head row address for a next row address group RAG. For example, the refresh manager 121 may increase the refresh target pointer value PT_TG by '3' so that the refresh target pointer value PT_TG points to the sixteenth row address RA16.

That is, after a regular refresh operation for a regular refresh command REF_R is completed, the refresh manager 121 may increase the refresh target pointer value PT_TG by '1' or more and '8 (e.g., the number of row addresses included in one row address group RAG)' or less.

According to the embodiment of FIG. 12, unlike the embodiment described above with reference to FIG. 10, the refresh manager 121 may perform a regular refresh operation in unit of row address group RAG. In this case, an operation of the refresh manager 121 based on the pointed row address RA_PTD may be implemented in a more concise form, so the complexity of the circuit configuration and production cost of the memory device 100 may be minimized. However, the scope of the present disclosure is not limited thereto.

Continuing with further reference to FIG. 13, the host device 10 may flexibly issue the regular refresh command REF_R and the fine-grained refresh command REF_F based on the refresh debit count DCNT. The horizontal axis of FIG. 13 may represent time, and the vertical axis may represent a value of the refresh debit count DCNT or a number of memory cell rows MCR refreshed per unit time.

Regular refresh periods for the memory bank 140 may occur at the twentieth time point t20, the twenty-first time point t21, and the twenty-second time point t22. For example, regular refresh periods for the memory bank 140 may being at the twentieth time point t20, the twenty-first time point t21, and the twenty-second time point t22. For a more concise explanation, below, it is assumed that the refresh debit count DCNT for the memory bank 140 is '0' before the twentieth time point t20.

The host device 10 may increase the refresh debit count DCNT by the skip cost CST_SKIP at every regular refresh period. For example, the host device 10 may increase the refresh debit count DCNT by the skip cost CST_SKIP at the twentieth time point t20, the twenty-first time point t21, and the twenty-second time point t22.

The host device 10 may decrease the refresh debit count DCNT to integer multiple of the skip cost CST_SKIP whenever the host device 10 issues the regular refresh command REF_R. Specifically, the host device 10 may decrease the refresh debit count DCNT by '1' to 'skip cost CST_SKIP' whenever the host device 10 issues the regular refresh command REF_R. For example, at the twenty-third time point t23, the host device 10 may issue a first regular refresh command REF_R1 and decrease the refresh debit count DCNT by the skip cost CST_SKIP.

The host device 10 may issue a plurality of fine-grained refresh commands REF_F between the twentieth time point t20 and the twenty-first time point t21. For example, the host device 10 may issue first to third fine-grained refresh commands REF_F1 to REF_F3 at twenty-fourth to twenty-sixth time points t24 to t26, respectively.

The host device 10 may decrease the refresh debit count DCNT by the 'unit redemption cost' whenever the host device 10 issues a fine-grained refresh command REF_F. For example, the host device 10 may decrease the refresh debit count DCNT by '1' each at the twenty-fourth to twenty-sixth time points t24 to t26.

The host device 10 may issue a second regular refresh command REF_R2 at twenty-seventh time point t27. In this case, the host device 10 may decrease the refresh debit count DCNT by '1' to 'skip cost CST_SKIP' so that the refresh debit count DCNT becomes an integer multiple of the skip cost CST_SKIP. For example, if the skip cost CST_SKIP is '5' and the refresh debit count DCNT before the twenty-seventh time point t27 is '2', the host device 10 may decrease the refresh debit count DCNT by '2' so that the refresh debit count DCNT becomes '0' (i.e., 0 times of the skip cost CST_SKIP).

Meanwhile, the host device 10 may determine whether to skip issuing a regular refresh command REF_R based on the refresh debit count DCNT. For example, the host device 10 may freely determine timing of issuing a regular refresh command REF_R (e.g., for skipping or delaying), similar to what was described above with reference to FIG. 4. That is, the host device 10 may maintain the refresh debit count DCNT does not go out of a predetermined refresh debit count range (e.g., to be in the predetermined refresh debit count range) at the regular refresh time point where the regular refresh periods begins, by flexibly issue the regular refresh command REF_R and the fine-grained refresh command REF_F. For a more detailed example, the host device 10 may skip issuing the regular refresh command REF_R at the twenty-eighth time point t28 and maintain the refresh debit count DCNT.

In this manner, the host device 10 may replace issuing a regular refresh command REF_R by issuing a plurality of fine-grained refresh commands REF_F. In this case, since the host device 10 may perform refresh scheduling for the memory bank 140 more flexibly, an operating efficiency of the memory system MS may be improved. In addition, according to embodiments of the present disclosure, the time required for the host device 10 to perform a regular refresh operation may be minimized, so that the input/output performance for the memory bank 140 may be improved.

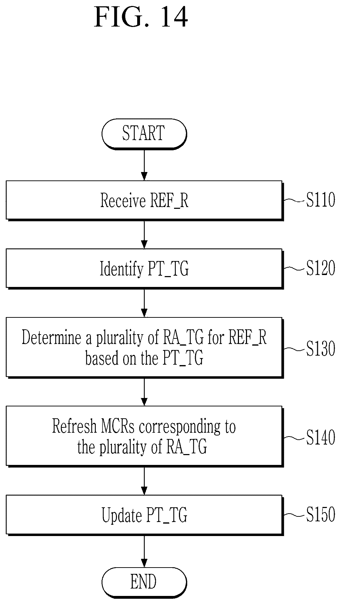

FIG. 14 is a flowchart showing an operation method of a memory device in response to a regular refresh command. Referring to FIGS. 1 to 14, at operation S110, the memory device 100 may receive a regular refresh command REF_R. For example, memory device 100 may receive the regular refresh command REF_R for the memory bank 140 in a form of command address signals CA.

At operation S120, the memory device 100 may identify a refresh target pointer value PT_TG. For example, the refresh manager 121 may identify the refresh target pointer value PT_TG that points one of a plurality of row addresses RA included in a refresh target determination list LST for the memory bank 140.

At operation S130, the memory device 100 may identify a plurality of refresh target row addresses RA_TG for the regular refresh command REF_R based on the refresh target pointer value PT_TG. For example, the refresh manager 121 may determine the plurality of refresh target row addresses RA_TG in a manner described above with reference to FIG. 10, or may determine the plurality of refresh target row addresses RA_TG in the manner described above with reference to FIG. 12.

At operation S140, the memory device 100 may refresh memory cell rows MCR corresponding to the plurality of refresh target row addresses RA_TG. For example, the refresh manager 121 may refresh memory cell rows MCR corresponding to the plurality of refresh target row addresses RA_TG simultaneously or sequentially.

At operation S150, the memory device 100 may update the refresh target pointer value PT_TG. For example, the refresh manager 121 may increase the refresh target pointer value PT_TG by a total number of the plurality of refresh target row addresses RA_TG determined in operation S130, similarly to what was previously described with reference to FIG. 10; or may update the refresh target pointer value PT_TG to point a group head row address for a next row address group RAG, similarly to what was previously described with reference to FIG. 12.

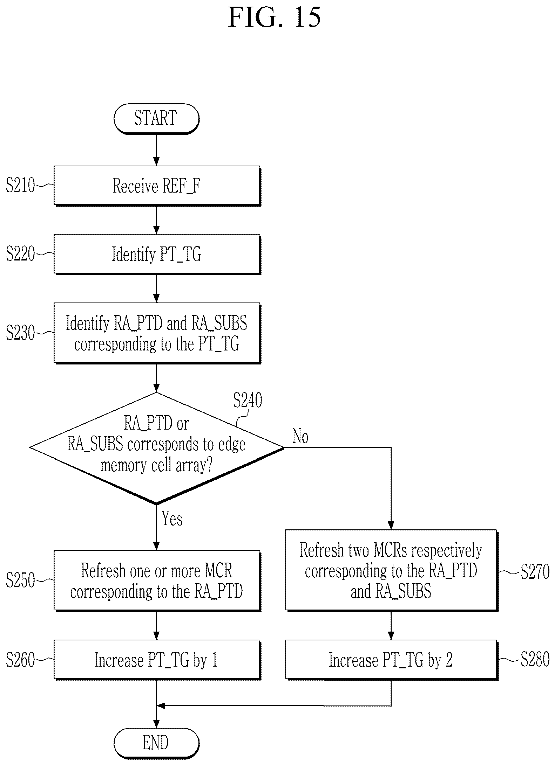

FIG. 15 is a flowchart showing an operation method of the memory device in response to a fine-grained refresh command. Referring to FIGS. 1 to 15, at operation S210, the memory device 100 may receive a fine-grained refresh command REF_F. At operation S220, the memory device 100 may identify a refresh target pointer value PT_TG. Since operations S210 and S220 are similar to operations S110 and S120 described above with reference to FIG. 14, so a detailed description is omitted.

At operation S230, the memory device 100 may identify a pointed row address RA_PTD and a subsequent row address RA_SUBS corresponding to the refresh target pointer value PT_TG. For example, the refresh manager 121 may identify a row address RA pointed by a refresh target pointer value PT_TG as the pointed row address RA_PTD, and may identify a row address RA having right after order to the pointed row address RA_PTD within the refresh target determination list LST as the subsequent row address RA_SUBS.

At operation S240, the memory device 100 may determine whether the pointed row address RA_PTD or the subsequent row address RA_SUBS corresponds to an edge memory cell array. For example, the refresh manager 121 may determine memory cell array type corresponding to each of the pointed row address RA_PTD and the subsequent row address RA_SUBS.

If it is determined that the pointed row address RA_PTD or the subsequent row address RA_SUBS corresponds to an edge memory cell array, operations S250 and S260 below may be performed. For example, if it is determined that at least one of the pointed row address RA_PTD and the subsequent row address RA_SUBS corresponds to an edge memory cell array type, the refresh manager 121 may perform operations S250 and S260 below.

If it is determined that the pointed row address RA_PTD and the subsequent row address RA_SUBS do not correspond to the edge memory cell array, operations S270 and S280 below may be performed. For example, if both the pointed row address RA_PTD and the subsequent row address RA_SUBS are determined to have internal memory cell array types, the refresh manager 121 may perform operations S270 and S280 below.

At operation S250, the memory device 100 may refresh one or more memory cell rows MCR corresponding to the pointed row address RA_PTD. For example, if the pointed row address RA_PTD corresponds to an edge memory cell array, the refresh manager 121 may refresh two memory cell rows MCR. When the pointed row address RA_PTD corresponds to an internal memory cell array, the refresh manager 121 may refresh one memory cell row MCR.

At operation S260, the memory device 100 may increase the refresh target pointer value PT_TG by '1'. For example, the refresh manager 121 may increase the refresh target pointer value PT_TG by '1'.

At operation S270, the memory device 100 may refresh two memory cell rows MCR corresponding to the pointed row address RA_PTD and the subsequent row address RA_SUBS, respectively. For example, the refresh manager 121 may simultaneously refresh one memory cell row MCR corresponding to the pointed row address RA_PTD and one memory cell row MCR corresponding to the subsequent row address RA_SUBS.

At operation S280, the memory device 100 may increase the refresh target pointer value PT_TG by '2'. For example, the refresh manager 121 may increase the refresh target pointer value PT_TG by '2'.

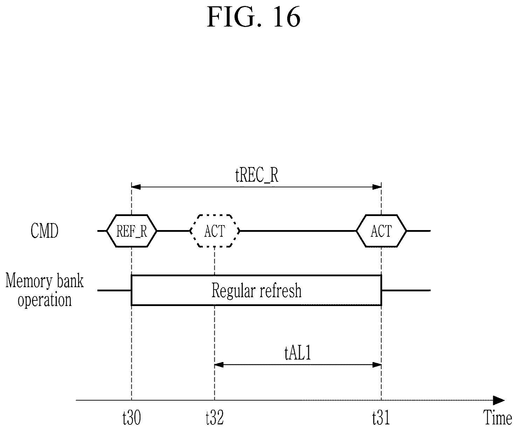

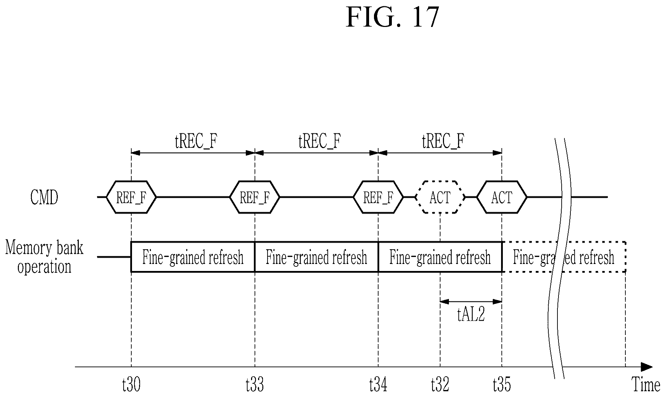

FIGS. 16 and 17 are timing diagrams showing operations of the memory system according to embodiments. The horizontal axis of FIGS. 16 and 17 may represent time.

First, referring to FIGS. 1 to 16, when the memory device 100 is in an idle state, the host device 10 may refresh data stored in the memory bank 140 by issuing a regular refresh command REF_R. For example, the host device 10 may issue a regular refresh command REF_R at a thirtieth time point t30.

The memory device 100 may perform a regular refresh operation during a regular refresh consumption time tRFC_R in response to the regular refresh command REF_R. For example, the memory device 100 may perform the regular refresh operation between the thirtieth time point t30 and a thirty-first time point t31.

Meanwhile, the host device 10 may need to access the memory bank 140 between the thirtieth time point t30 and the thirty-first time point t31. However, during the regular refresh consumption time tRFC_R, the host device 10 cannot issue an activation command ACT for the memory bank 140. For example, even if a need for access to the memory bank 140 of the host device 10 occurs at a time point t32 between the thirtieth time point t30 and the thirty-first time point t31, issuance of an activation command ACT for the memory bank 140 of the host device 10 may be prohibited until the thirty-first time point t31.

The time interval between the thirty-second time point t32 and the thirty-first time point t31 may be referred to as a first activation delay time tAL1. That is, due to the regular refresh operation, the first activation delay time tAL1 may occur for accessing for the memory bank 140 of the host device 10.

On the other hand, referring further to FIG. 17, when the memory device 100 is in an idle state, the host device 10 may sequentially refresh data stored in the memory bank 140 by issuing a plurality of fine-grained refresh commands REF_F. That is, instead of issuing a regular refresh command REF_R at the thirtieth time point t30, the host device 10 may sequentially issue a plurality of fine-grained refresh commands REF_F. For example, the host device 10 may plan to issue a fine-grained refresh command REF_F every time the fine-grained refresh consumption time tRFC_F elapses from the thirtieth time point t30. For a more detailed example, the host device 10 may plan to issue a fine-grained refresh command REF_F each at a thirty-third time point t33, a thirty-fourth time point t34, and a thirty-fifth time point t35.

Meanwhile, similar to what was explained with reference to FIG. 16 above, a need to access for the memory bank 140 of the host device 10 may occur at thirty-second time point t32. However, an issuance of the activation command ACT of the host device 10 may be prohibited until the fine-grained refresh operation between the thirty-fourth time point t34 and the thirty-fifth time point t35 is completed. That is, the host device 10 may have to wait for issuance of the activation command ACT until the fine-grained refresh consumption time tRFC_F elapses from the thirty-fourth time point t34. In this case, at the thirty-fifth time point t35, the host device 10 may issue the activation command ACT instead the fine-grained refresh command REF_F .

The time interval between the thirty-second time point t32 and the thirty-fifth time point t35 may be referred to as a second activation delay time tAL2. That is, due to the fine-grained refresh operation, the second activation delay time tAL2 may occur for accessing for the memory bank 140 of the host device 10.

The second activation delay time tAL2 may be shorter than the first activation delay time tAL1. That is, when the host device 10 controls refresh operations for the memory bank 140 based on a plurality of fine-grained refresh command REF_F, the time that the host device 10 should wait to issue the activation command ACT may be reduced compared to when the host device 10 controls refresh operations for the memory bank 140 based on a regular refresh command REF_R.

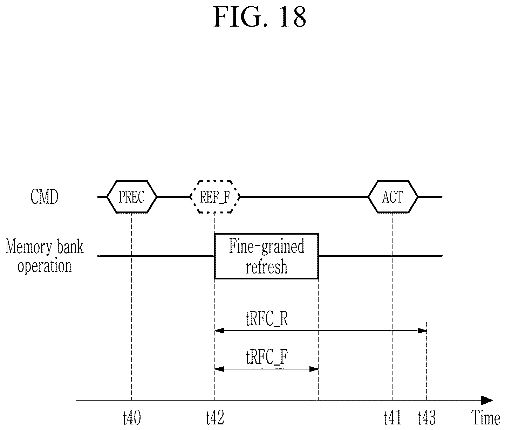

FIG. 18 is a timing diagram showing an operation of the memory system according to embodiments. Referring to FIGS. 1 to 18, at a fortieth time point t40, the host device 10 may issue a precharge command PREC for the memory bank 140. In this case, the memory bank 140 may enter an idle state.

The host device 10 may need to access the memory bank 140 at a forty-first time point t41. At a forty-second time point t42 between the fortieth time point t40 and the forty-first time point t41, the host device 10 may try to perform refresh operation for the memory bank 140.

The interval between the forty-second time point t42 and the forty-first time point t41 may be shorter than the regular refresh consumption time tRFC_R. For example, the forty-third time point t43 after the regular refresh consumption time tRFC_R has elapsed from the forty-second time point t42 may be a time point after the forty-first time point t41. In this case, in order for the host device 10 to issue the activation command ACT at the forty-first time point t41, the host device 10 should not issue a regular refresh command REF_R at the forty-second time point t42.

On the other hand, the interval between the forty-second time point t42 and the forty-first time point t41 may be longer than the fine-grained refresh consumption time tRFC_F. In this case, even if the host device 10 issues a fine-grained refresh command REF_F at the forty-second time point t42, the host device 10 may able to issue the activation command ACT at the forty-first time point t41.

That is, according to embodiments of the present disclosure, the host device 10 may issue the fine-grained refresh command REF_F even when a time margin is insufficiently guaranteed to issue the regular refresh command REF_R. In this case, a time length that the memory bank 140 remains in the idle state may be minimized, and the operating efficiency of the memory system MS may be maximized.

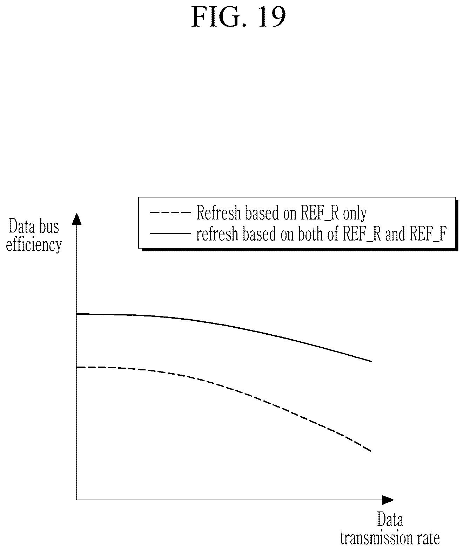

FIG. 19 is a graph showing an effect of fine-grained refresh according to embodiments of the present disclosure. Referring to FIGS. 1 to 19, the horizontal axis of FIG. 19 may represent a data transmission rate between the memory device 100 and the host device 10. The vertical axis of FIG. 19 may represent data bus efficiency. For example, the vertical axis of FIG. 19 may represent a ratio of a time that the data bus transmits data to a total operating time of the memory device 100.

A data bus efficiency of when the host device 10 controls the refresh operation for the memory device 100 only based on the regular refresh command REF_R is shown by a dotted line. A data bus efficiency of when the host device 10 controls the refresh operation for the memory device 100 based on the regular refresh command REF_R and the fine-grained refresh command REF_F is shown as a solid line.

The host device 10 may refresh the memory bank 140 by issuing the regular refresh command REF_R at every regular refresh period. In this case, the host device 10 may not be able to access the memory device 100 for the regular refresh consumption time tRFC_R for each regular refresh period.

The host device 10 may refresh the memory bank 140 by flexibly issuing the regular refresh command REF_R and the fine-grained refresh command REF_F. For example, the host device 10 may issue the regular refresh command REF_R every regular refresh period, or may issue a plurality of fine-grained refresh commands REF_F instead of the regular refresh command REF_R.

Therefore, according to embodiments of the present disclosure, a phenomenon in which communication between the host device 10 and the memory device 100 is limited due to the regular refresh consumption time tRFC_R may be minimized. Accordingly, referring to both of a graph illustrated in the dotted line and a graph illustrated in the solid line, when the host device 10 controls the refresh operation for the memory device 100 based on the regular refresh command REF_R and the fine-grained refresh command REF_F, data bus efficiency may be improved.

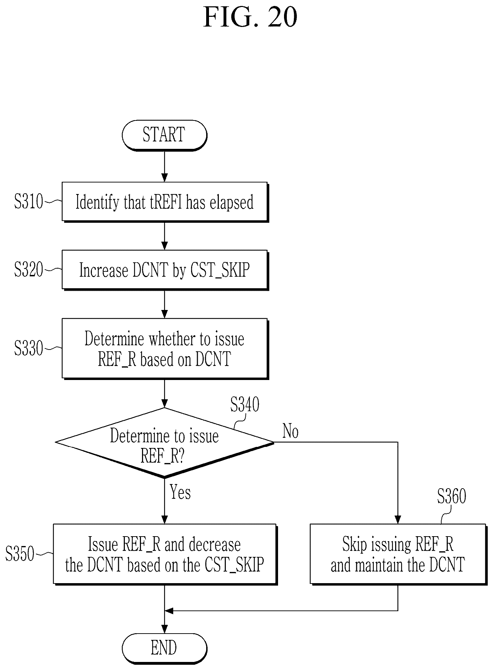

FIG. 20 is a flowchart showing regular refresh scheduling of the host device according to embodiments. Referring to FIGS. 1 to 20, at operation S310, the host device 10 may identify that a time length corresponding to a regular refresh interval tREFI has elapsed. For example, the refresh scheduling circuit 14 may identify that a new regular refresh period has begun based on the timer circuit 13.

At operation S320, the host device 10 may increase the refresh debit count DCNT by the skip cost CST_SKIP. For example, the refresh debit counter 12 may increase the refresh debit count DCNT by the skip cost CST_SKIP.

At operation S330, the host device 10 may determine whether to issue a regular refresh command REF_R based on the refresh debit count DCNT. For example, the refresh scheduling circuit 14 may determine whether to issue the regular refresh command REF_R as long as the refresh debit count DCNT at beginning of a next regular refresh period does not exceed a predetermined refresh debit count range.

At operation S340, the host device 10 may determine whether it has decided to issue the regular refresh command REF_R. If the host device 10 decides to issue the regular refresh command REF_R, the following operation S350 may be performed. If the host device 10 decides not to issue a regular refresh command REF_R, the following operation S360 may be performed.

At operation S350, the host device 10 may issue the regular refresh command REF_R and decrease the refresh debit count DCNT based on the skip cost CST_SKIP. For example, if the memory system MS is implemented in a manner described above with reference to FIGS. 10 and 11, the refresh debit counter 12 may decrease the refresh debit count DCNT by the skip cost CST_SKIP. When the memory system MS is implemented in a manner described above with reference to FIGS. 12 and 13, the refresh debit counter 12 may decrease the refresh debit count DCNT by '1' to the skip cost CST_SKIP, so that the refresh debit count DCNT becomes an integer multiple of the skip cost CST_SKIP.

At operation S360, the host device 10 may skip or postpone issuing the regular refresh command REF_R and maintain the refresh debit count DCNT. For example, if the regular refresh command REF_R is not issued, the refresh debit counter 12 may not change the refresh debit count DCNT.

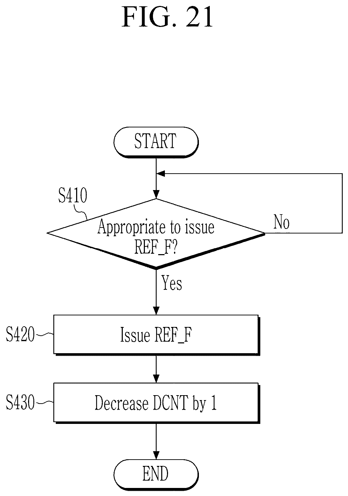

FIG. 21 is a diagram showing fine-grained refresh scheduling of the host device according to embodiments. Referring to FIGS. 1 to 21, at operation S410, the host device 10 may determine whether it is appropriate to issue a fine-grained refresh command REF_F. For example, the refresh scheduling circuit 14 may determine whether it is appropriate to issue the fine-grained refresh command REF_F based on various factors, such as whether the memory bank 140 is precharged, whether another command is scheduled to be issued for the memory bank 140 during a fine-grained refresh consumption time tRFC_F from a time point where the operation S410 is performed, a size of the refresh debit count DCNT, etc. However, the scope of the present disclosure is not limited thereto, and the host device 10 may manage a command queue that temporarily stores commands CMD to be issued to the memory device 100. In this case, the host device 10 may determine whether it is appropriate to issue the fine-grained refresh command REF_F, based on whether command CMD for the memory bank 140 is queued in the command queue.

In operation S410, if it is determined that it is appropriate to issue the fine-grained refresh command REF_F, the host device 10 may perform operation S420 below. In operation S410, if it is determined that it is not appropriate to issue the fine-grained refresh command REF_F, the host device 10 may repeat operation S410. In this way, the host device 10 may await an appropriate time point to issue the fine-grained refresh command REF_F, and then perform the following operation S420.

At operation S420, the host device 10 may issue a fine-grained refresh command REF_F. For example, the refresh scheduling circuit 14 may control the command issuance circuit 11 to issue the fine-grained refresh command REF_F for the memory bank 140.

At operation S430, the host device 10 may decrease the refresh debit count DCNT by '1'. For example, the refresh debit counter 12 may decrease the refresh debit count DCNT by '1'.

In embodiments, the host device 10 may repeat operation S410 described above after operation S430 is performed. That is, the host device 10 may repeatedly issue the fine-grained refresh command REF_F whenever it is appropriate to issue the fine-grained refresh command REF_F. In this case, a probability that the host device 10 skips issuing the regular refresh command REF_R in operation S340 described above with reference to FIG. 20 may increase. Therefore, according to the embodiment of the present disclosure, the input/output performance degradation for the memory bank 140 due to the regular refresh consumption time tRFC_R may be minimized.

FIG. 22 is a diagram showing an operation of the memory system according to embodiments. Referring to FIGS. 1 to 9 and FIGS. 12 to 22, the refresh target determination list LST may be implemented as a following refresh target determination list LSTc.

The refresh target determination list LSTc may include a plurality of row addresses RA. For example, the refresh target determination list LSTc may include the first to eighth row addresses RAa to RAh.

Similar to what was described above with reference to FIG. 12, the refresh target determination list LSTc may include a plurality of row address groups RAGs. Each of the plurality of row address groups RAGs may include a plurality of row addresses RAs. For example, the third row address group RAGc may include the first to eighth row addresses RAa to RAh. In this case, the first row address RAa may be referenced as a group head row address for the third row address group RAGc. For brevity, only one row address group RAG is illustrated in FIG. 22, but the scope of the present disclosure is not limited thereto.

The refresh manager 121 may determine refresh target row addresses RA_TG for the regular refresh command REF_R in a similar manner as described above with reference to FIG. 12.

The refresh target determination list LSTc may be implemented so that the refresh manager 121 always performs refresh operation for two memory cell rows in response to a fine-grained refresh command REF_F. In other words, the refresh target determination list LSTc may be implemented to prevent a situation of that the refresh manager 121 performs refresh operation for only one memory cell row MCR in response to a fine-grained refresh command REF_F (e.g., when a pointed row address RA_PTD corresponds to an internal memory cell array and a subsequent row address RA_SUBS corresponds to an edge memory cell array).

More specifically, among row addresses RA included in each row address group RAG in the refresh target determination list LSTc, there may be even number of edge row addresses (e.g., 0 or multiple of 2); these edge row address may have a consecutive order with each other in the refresh target determination list LSTc; and an edge row address having a highest order among the edge row addresses in each row address group RAG may have an odd order in the row address group RAG. For example, among the first to eighth row addresses RAa to RAh included in the third row address group RAGc, a number of row addresses RA corresponding to the edge memory cell array may be an even number (for example, the fifth and sixth row addresses RAe and RAf, therefore '2'); the fifth and sixth row addresses RAe and RAf may have consecutive orders within the refresh target determination list LSTc; and the fifth row address RAe, which has a highest order among the fifth and sixth row addresses RAe and RAf, may have an odd order (for example, the fifth) within the row address group RAG.

Accordingly, when a fine-grained refresh command REF_F is received, both the pointed row address RA_PTD and the subsequent row address RA_SUBS may correspond to the internal memory cell array, or the pointed row address RA_PTD may correspond to the edge memory cell array. In other words, a situation in which the pointed row address RA_PTD corresponds to the internal memory cell array and only the subsequent row address RA_SUBS corresponds to the edge memory cell array may be prevented. In this case, in response to a fine-grained refresh command REF_F, the refresh manager 121 may perform refresh operation for two row addresses corresponding to the internal memory cell array or perform refresh operation for one row address corresponding to the edge memory cell array.

For a more detailed example, when the first fine-grained refresh command REF_Fa is received, both the pointed row address RA_PTD and the subsequent row address RA_SUBS may correspond to the internal memory cell array. In this case, the refresh manager 121 may perform refresh operation for the first and second row addresses RAa, RAb. Similarly, when a second fine-grained refresh command REF_Fb is received, the refresh manager 121 may perform refresh operation for the third and fourth row addresses RAc, RAd.

When the third fine-grained refresh command REF_Fc is received, both the pointed row address RA_PTD (i.e., the fifth row address RAe) and the subsequent row address RA_SUBS (i.e., the sixth row address RAf) may correspond to the edge memory cell array. In this case, the refresh manager 121 may perform refresh operation for two memory cell rows MCR corresponding to the fifth row address RAe.

When the fourth fine-grained refresh command REF_Fd is received, the pointed row address RA_PTD (i.e., the sixth row address RAf) may correspond to the edge memory cell array, and the subsequent row address RA_SUBS (i.e., the seventh row address RAg) may correspond to the internal memory cell array. In this case, the refresh manager 121 may perform refresh operation for two memory cell rows MCR corresponding to the sixth row address RA6.

Thereafter, when the fifth fine-grained refresh command REF_Fe is received, both the pointed row address RA_PTD and the subsequent row address RA_SUBS may correspond to the internal memory cell array. In this case, the refresh manager 121 may perform a refresh operation for the first and second row addresses RAa, RAb.

That is, according to the embodiment of FIG. 22, a constant number of memory cell rows MCR (e.g., two) may always be refreshed in response to a fine-grained refresh command REF_F. In this case, a number of fine-grained refresh commands REF_F that need to be issued to refresh a specific number of memory cell rows MCR may be minimized.

In embodiments, among the row addresses RA included in one row address group RAG, a number of row addresses RA corresponding to an edge memory cell array may be 0 or 2. In this case, a number of memory cell rows MCR corresponding to each row address group RAG may be more uniform. For example, comparing in case of a number of row addresses RA corresponding to edge memory cell arrays among the row addresses RA included in each row address group RAG is implemented as an arbitrary number such as 0, 2, 4, or 8, a number of row addresses RA corresponding to edge memory cell arrays among the row addresses RA included in each row address group RAG is implemented as only 0 or 2, a deviation of memory cell rows MCR corresponding to each row address group RAG may be smaller. Therefore, according to embodiments of the present disclosure, a time and power required to perform a regular refresh operation for the memory bank 140 in response to a plurality of regular refresh commands REF_R may be uniform relatively.

In embodiments, the refresh target determination list LST described with reference to FIGS. 1 to 9 and FIGS. 12 to 21 may be implemented in the manner described with reference to FIG. 22. In this case, both the pointed row address RA_PTD and the subsequent row address RA_SUBS when the fine-grained refresh command REF_F is received may correspond to the internal memory cell array, or at least the pointed row address RA_PTD may correspond to the edge memory cell array. Accordingly, the memory device 100 may determine whether to perform a refresh operation for one row address RA or two row addresses RA in response to a fine-grained refresh command REF_F by considering only the pointed row address RA_PTD (i.e., without considering the subsequent row address RA_SUBS).

FIG. 23 is a flowchart showing an operation method of the memory device in response to a fine-grained refresh command, when the refresh target determination list is implemented in a manner described with reference to FIG. 22. Referring to FIGS. 1 to 9 and FIGS. 12 to 23, the refresh target determination list LST may be implemented as the refresh target determination list LSTc.

At operation S510, the memory device 100 may receive a fine-grained refresh command REF_F. At operation S520, the memory device 100 may identify a refresh target pointer value PT_TG. Since operations S510 and S520 are similar to operations S210 and S220 described above with reference to FIG. 15, so a detailed description is omitted.

At operation S530, the memory device 100 may identify a pointed row address RA_PTD corresponding to the refresh target pointer value PT_TG. For example, the refresh manager 121 may identify a row address RA pointed by the refresh target pointer value PT_TG as the pointed row address RA_PTD.

At operation S540, the memory device 100 may determine whether the pointed row address RA_PTD corresponds to an edge memory cell array. For example, the refresh manager 121 may determine a memory cell array type corresponding to the pointed row address RA_PTD.

That is, unlike operations S230 and S240, the refresh manager 121 may only determine the memory cell array type for the pointed row address RA_PTD. In other words, even if the refresh manager 121 does not determine the memory cell array type for the subsequent row address RA_SUBS, similarly to what was described with reference to operations S230 and S240 above, the refresh manager 121 may be able to successfully determine whether the pointed row address RA_PTD or the subsequent row address RA_SUBS corresponds to the edge memory cell array. In this case, an operation load of the refresh manager 121 may be reduced.

If it is determined that the pointed row address RA_PTD corresponds to the edge memory cell array, operations S550 and S560 below may be performed. If it is determined that the pointed row address RA_PTD corresponds to the internal memory cell array, operations S570 and S580 below may be performed.

At operation S550, the memory device 100 may refresh two memory cell rows MCR corresponding to the pointed row address RA_PTD. At operation S560, the memory device 100 may increase the refresh target pointer value PT_TG by '1'.

At operation S570, the memory device 100 may refresh two memory cell rows MCR corresponding to the pointed row address RA_PTD and the subsequent row address RA_SUBS, respectively. At operation S580, the memory device 100 may increase the refresh target pointer value PT_TG by '2'.

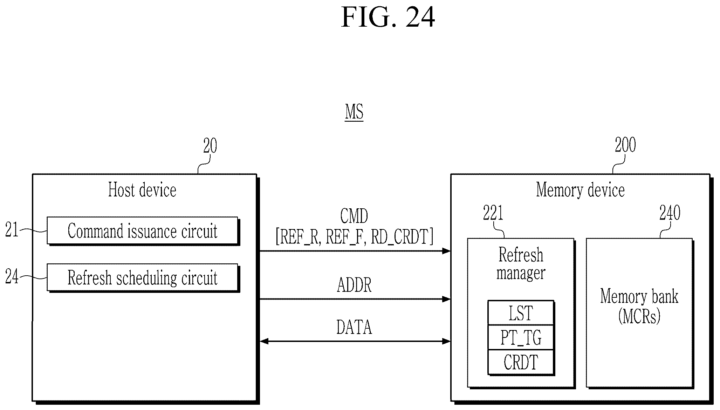

FIG. 24 is a block diagram showing a memory system according to embodiments. Referring to FIGS. 1 to 24, a memory system MS may include a host device 20 and a memory device 200. The host device 20 may include a command issuance circuit 21 and a refresh scheduling circuit 24. The memory device 200 may include a refresh manager 221 and a memory bank 240.

The command issuance circuit 21 may issue regular refresh command REF_R and fine-grained refresh command REF_F.

The refresh manager 221 may manage a refresh target determination list LST, a refresh target pointer value PT_TG, and a refresh credit count CRDT. The manner in which the refresh target determination list LST and the refresh target pointer value PT_TG are used is similar to that described above with reference to FIGS. 1 to 23, so a detailed description is omitted.

The refresh credit count CRDT may indicate an extent to which a refresh operation has been performed in advance for the memory bank 240. For example, the refresh manager 221 may decrease the refresh credit count CRDT at every regular refresh period and may increase the refresh credit count CRDT whenever the regular refresh command REF_R or the fine-grained refresh command REF_F are received from the host device 10.

The refresh scheduling circuit 24 may control the command issuance circuit 21 to issue a credit count read command RD_CRDT. That is, the command issuance circuit 21 may issue the credit count read command RD_CRDT in response to a control of the refresh scheduling circuit 24. The refresh manager 221 may provide the refresh credit count CRDT to the host device 10 in response to the credit count read command RD_CRDT.

In embodiments, the command issuance circuit 21 may issue the credit count read command RD_CRDT periodically in response to the control of the refresh scheduling circuit 24. For example, the command issuance circuit 21 may issue the credit count read command RD_CRDT at every regular refresh interval tREFI or issue the credit count read command RD_CRDT whenever a time length corresponding to a multiplication of the refresh fluctuation threshold and regular refresh interval tREFI. However, the scope of the present disclosure is not limited thereto. For example, the command issuance circuit 21 may issue the credit count read command RD_CRDT irregularly in response to the control of the refresh scheduling circuit 24.

In embodiments, the refresh manager 221 may store the refresh credit count CRDT in a mode register of the memory device 200. In this case, the credit count read command RD_CRDT may have a form of a mode register read (MRR) command. However, the scope of the present disclosure is not limited thereto.

The refresh scheduling circuit 24 may control an operation of the command issuance circuit 21 based on the refresh credit count CRDT. For example, the refresh scheduling circuit 24 may determine when to issue the regular refresh command REF_R and the fine-grained refresh command REF_F of the command issuance circuit 21 based on the refresh credit count CRDT.

That is, according to the embodiment of FIG. 24, unlike what was described above with reference to FIGS. 1 to 23, instead of the host device 20, the memory device 200 may manage the extent to which a refresh operation has been performed for the memory bank 240. In this case, the operating load of the host device 10 may be reduced since the host device 10 may not manage the refresh debit count DCNT. However, the scope of the present disclosure is not limited thereto, and the host device 20 may also manage a refresh debit count DCNT similarly to that described above with reference to FIGS. 1 to 23, and the memory device 200 may manage a refresh credit count CRDT. In this case, the refresh scheduling circuit 24 will be able to perform refresh scheduling more efficiently.

For a more concise explanation, FIG. 24 illustrates embodiments in which the host device 20 reads the refresh credit count CRDT from the memory device 200, but the scope of the present disclosure is not limited thereto. For example, instead of directly reading the refresh credit count CRDT from the memory device 200, the host device 20 may be implemented to read various types of data generated based on the refresh credit count CRDT, or may be implemented to read the refresh target pointer value PT_TG from the memory device 200. That is, the scope of the present disclosure is not limited to the format of specific data that the host device 20 uses for refresh scheduling.

Also, for a more concise explanation, embodiments in which the host device 20 issues the credit count read command RD_CRDT is described in FIG. 24, but the scope of the present disclosure is not limited thereto. For example, instead of issuing a command CMD, the host device 20 may be implemented to read the refresh credit count CRDT from the memory device 200 through various paths, such as a side band channel.

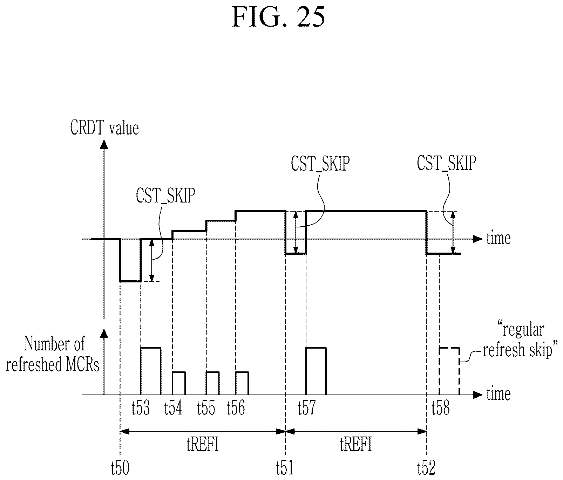

FIG. 25 is a timing diagram showing how the memory device of FIG. 24 manages the refresh credit count. The horizontal axis of FIG. 25 may represent time, and the vertical axis may represent a value of the refresh credit count CRDT or a number of memory cell rows MCR refreshed per unit time.

Referring to FIGS. 1 to 25, the memory device 200 may sequentially receive a plurality of regular refresh commands REF_R and a plurality of fine-grained refresh commands REF_F from a host device 20.

Regular refresh periods for the memory bank 240 may occur at the fiftieth time point t50, the fifty-first time point t51, and the fifty-second time point t52. For example, a regular refresh period for a memory bank 240 may start at a fiftieth time point t50, a fifty-first time point t51, and a fifty-second time point t52. For a more concise explanation, below, it is assumed that the refresh credit count CRDT for the memory bank 240 is '0' before the fiftieth time point t50.

The refresh manager 221 may decrease the refresh credit count CRDT by the skip cost CST_SKIP at each regular refresh period. For example, the host device 20 may decrease the refresh credit count CRDT by the skip cost CST_SKIP each at the fiftieth time point t50, the fifty-first time point t51, and the fifty-second time point t52.

The refresh manager 221 may increase the refresh credit count CRDT by the skip cost CST_SKIP whenever the regular refresh command REF_R is received. For example, the refresh manager 221 may receive a regular refresh command REF_R at a fifty-third time point t53. In this case, the refresh manager 221 may increase the refresh credit count CRDT to '0'.

The refresh manager 221 may sequentially receive a plurality of fine-grained refresh commands REF_F between the fiftieth time point t50 and the fifty-first time point t51. For example, the refresh manager 221 may receive a fine-grained refresh command REF_F at each of the fifty-fourth to fifty-sixth time points t54 to t56.

The refresh manager 221 may increase the refresh credit count CRDT by '1' whenever the fine-grained refresh command REF_F is received. For example, the refresh manager 221 may increase the refresh credit count CRDT by '1' each at the fifty-fourth to fifty-sixth time points t54 to t56.

The refresh manager 221 may receive the regular refresh command REF_R at fifty-seventh time point t57. In this case, the refresh manager 221 may increase the refresh credit count CRDT by the skip cost CST_SKIP. However, the scope of the present disclosure is not limited thereto, and a size how much the refresh manager 221 increases the refresh credit count CRDT in response to the regular refresh command REF_R may vary depending on an operation of the refresh manager 221 based on the refresh target determination list LST. For example, if the memory device 200 is implemented to determine refresh target row addresses RA_TG in a manner described above with reference to FIG. 10 in response to a regular refresh command REF_R, the refresh manager 221 may increase the refresh credit count CRDT by the skip cost CST_SKIP; if the memory device 200 is implemented to determine the refresh target row addresses RA_TG in a manner described above with reference to FIG. 12 in response to the regular refresh command REF_R, the refresh manager 221 may increase the refresh credit count CRDT by '1' to the skip cost CST_SKIP whenever the regular refresh command REF_R is received so that the refresh credit count CRDT becomes an integer multiple of the skip cost CST_SKIP.

Meanwhile, the host device 20 may determine whether to skip issuing the regular refresh command REF_R based on the refresh credit count CRDT. For example, the host device 20 may freely determine a timing of issuing the regular refresh command REF_R (e.g., through skipping or delaying), similar to what was described above with reference to FIG. 4. For a more detailed example, the host device 20 may skip issuing the regular refresh command REF_R at a fifty-eighth time point t58. In this case, the refresh manager 221 may maintain the refresh credit count CRDT.

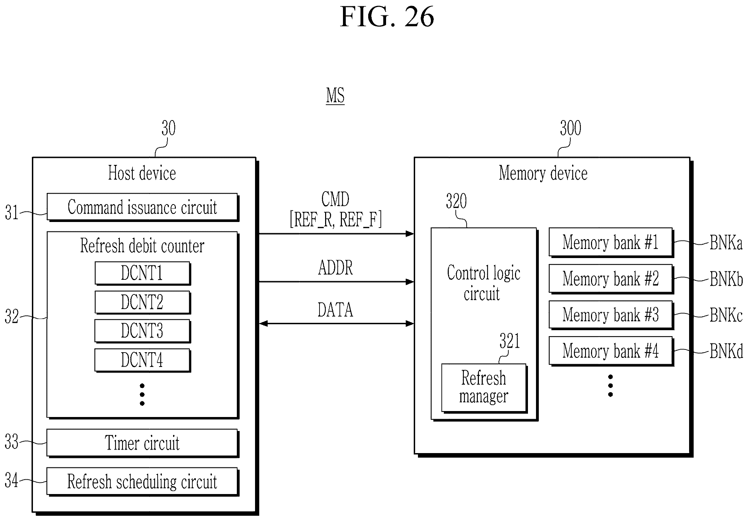

FIG. 26 is a block diagram showing a memory system according to embodiments. Referring to FIGS. 1 to 23 and FIG. 26, a memory system MS may include a host device 30 and a memory device 300.

The memory device 300 may include a plurality of memory banks BNKs. For example, the memory device 300 may include first to fourth memory banks BNKa to BNKd. However, the scope of the present disclosure is not limited to a number of memory banks BNKs included in the memory device 300.

In embodiments, one of the plurality of memory banks BNKs may correspond to the memory bank 140 described above with reference to FIGS. 1 to 23.

The memory device 300 may include a control logic circuit 320. The control logic circuit 320 may include a refresh manager 321. The refresh manager 321 may determine a refresh order for memory cells included in each of the plurality of memory banks BNKs.

The host device 30 may include a command issuance circuit 31, a refresh debit counter 32, a timer circuit 33, and a refresh scheduling circuit 34. The functions of the command issuance circuit 31, the timer circuit 33, and the refresh scheduling circuit 34 are similar to the functions of the command issuance circuit 11, the timer circuit 13, and the refresh scheduling circuit 14 described above with reference to FIGS. 1 to 23, and therefore, a detailed description thereof is omitted.

The refresh debit counter 32 may manage a plurality of refresh debit counts DCNT respectively corresponding to the plurality of memory banks BNK. For example, the refresh debit counter 32 may manage first to fourth refresh debit counts DCNT1 to DCNT4 corresponding to the first to fourth memory banks BNKa to BNKd, respectively.

For a more detailed example, the refresh debit counter 32 may increase the first to fourth refresh debit counts DCNT1 to DCNT4 at every regular refresh period. The refresh debit counter 32 may decrease the refresh debit count DCNT corresponding to a memory bank BNK corresponding to the regular refresh command REF_R and the fine-grained refresh command REF_F issued by the command issuance circuit 31. For example, when the command issuance circuit 31 issues a regular refresh command REF_R or a fine-grained refresh command REF_F for the first memory bank BNKa, the refresh debit counter 32 may decrease the first refresh debit count DCNT1. On the other hand, when the command issuance circuit 31 issues a regular refresh command REF_R or a fine-grained refresh command REF_F for the second memory bank BNKb, the refresh debit counter 32 may decrease the second refresh debit count DCNT2.

The refresh scheduling circuit 34 may control an operation of the command issuance circuit 31 based on the plurality of refresh debit counts DCNT. For example, the refresh scheduling circuit 34 may determine an issuance schedule of the command issuance circuit 31, regarding to the regular refresh command REF_R and fine-grained refresh command REF_F for each memory bank BNK, based on the plurality of refresh debit counts DCNT.

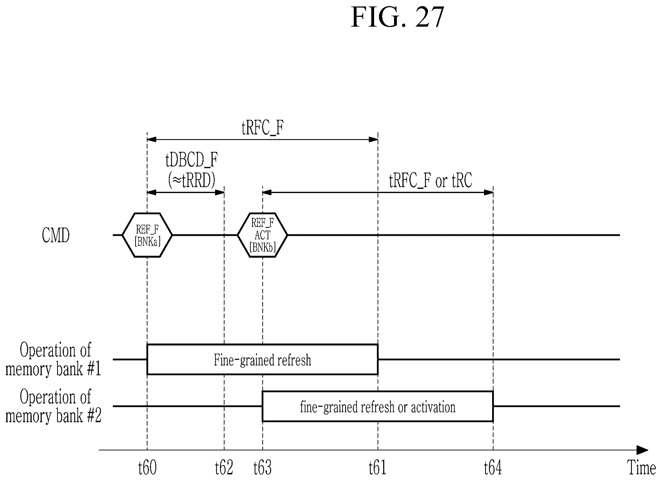

FIG. 27 is a timing diagram showing an operation of the memory system according to the embodiment of FIG. 26. The horizontal axis of FIG. 27 may represent time.

Referring to FIGS. 1 to 23 and FIGS. 26 to 27, at a sixtieth time point t60, the host device 30 may issue a fine-grained refresh command REF_F for the first memory bank BNKa. In this case, the memory device 300 may perform a fine-grained refresh operation for the first memory bank BNKa between the sixtieth time point t60 and a sixty-first time point t61. The time interval between the sixtieth time point t60 and the sixty-first time point t61 may be the fine-grained refresh consumption time tRFC_F.

After the sixtieth time point t60, control of the host device 30 for memory banks other than the first memory bank BNKa may be prohibited for a certain time length. For example, after the sixtieth time point t60, issuing of a fine-grained refresh command REF_F and an activation command ACT for other memory bank of the host device 30 may be prohibited for an 'other bank control delay after fine-grained refresh tDBCD_F'. For a more detailed example, issuance of a fine-grained refresh command REF_F and an activation command ACT for the second memory bank BNKb of the host device 30 may be prohibited from a sixtieth point in time t60 to a sixty-second time point t62 after the 'other bank control delay after fine-grained refresh tDBCD_F' has elapsed.

In embodiments, the 'other bank control delay after fine-grained refresh tDBCD_F' may have same length as an 'activation-to-activation delay for other bank tRRD'. However, the scope of the present disclosure is not limited thereto, and 'other bank control delay after fine-grained refresh tDBCD_F' may have a length similar to the 'activation-to-activation delay for other bank tRRD'.

In embodiments, the 'activation-to-activation delay for other bank tRRD' may refer to a minimum time interval required when the host device 30 issues an activation command CMD for a specific memory bank and then issues an activation command CMD for another memory bank.

The host device 30 may issue a fine-grained refresh command REF_F or an activation command ACT to the second memory bank BNKb after the sixty-second time point t62. For example, the host device 30 may issue the fine-grained refresh command REF_F or the activation command ACT for the second memory bank BNKb at a sixty-third time point t63. In this case, the memory device 300 may perform a fine-grained refresh operation or an activation operation for the second memory bank BNKb between the sixty-third time point t63 and a sixty-fourth time point t64. In this case, the time interval between between the sixty-third time point t63 and a sixty-fourth time point t64 may be the fine-grained refresh consumption time tRFC_F or the same bank activation minimum interval tRC described above.

In embodiments, the time interval between the sixtieth time point t60 and the sixty-third time point t63 may be equal to or longer than the 'activation-to-activation delay for other bank tRRD'.

In embodiments, the time interval between the sixtieth time point t60 and the sixty-third time point t63 may be shorter than the fine-grained refresh consumption time tRFC_F. For example, the host device 30 may issue the fine-grained refresh command REF_F for a specific memory bank BNK and then, before a refresh operation for that memory bank BNK is completed, the host device 30 may issue a fine-grained refresh command REF_F or an activation command ACT for another memory bank BNK.

In embodiments, the time interval between the sixtieth time point t60 and the sixty-third time point t63 may be shorter than 'a regular refresh-regular refresh delay for other bank (e.g., which may be referred to as "tpbR2pbR")'. That is, when the host device 30 is implemented to issue the fine-grained refresh command REF_F according to embodiments of the present disclosure, a phenomenon of the host device 30 being delayed in issuing a regular refresh command REF_R for a specific memory bank, which occurs in order for the host device 30 to issue a regular refresh command REF_R for other memory bank, may be prevented. Therefore, according to the embodiment of the present disclosure, the operational efficiency of the memory system MS may be improved.

## Claims

1. An operation method of a memory device including a memory bank (140; 240; BNKa to BNKd), which includes a plurality of edge memory cell arrays (141_1, 141_n) and a plurality of internal memory cell arrays (141_2 to 141_n-1) arranged between the plurality of edge memory cell arrays (141_1, 141_n), the operation method comprising:

   receiving (S210) a fine-grained refresh command (REF_F);
   identifying (S210) a refresh target pointer value (PT_TG) for a refresh target determination list (LST), which includes a plurality of row addresses for the memory bank (140; 240; BNKa to BNKd);
   identifying (S230) a pointed row address (RA_PTD) corresponding to the refresh target pointer value (PT_TG), among the plurality of row addresses;
   determining (S240) a first memory cell array type corresponding to the pointed row address (RA_PTD); and
   performing (S250, S270) a first refresh operation for a refresh target number of fine-grained refresh target row addresses (RA_TG), wherein the refresh target number is determined based on the first memory cell array type.

2. The operation method of claim 1, wherein: the first refresh operation is performed simultaneously for as many memory cell rows as a maximum number of concurrently active wordlines for activation command.

3. The operation method of claim 1 or 2, wherein, when the first memory cell array type is an edge memory cell array type corresponding to the plurality of edge memory cell arrays (141_1, 141_n), the performing comprises:

determining the pointed row address (RA_PTD) as a first fine-grained refresh target row address (RA_TG); and

refreshing (S250) first and second memory cell rows corresponding to the first fine-grained refresh target row address (RA_TG) simultaneously.

4. The operation method of claim 3, wherein, when the first memory cell array type is an internal memory cell array type corresponding to the plurality of internal memory cell arrays (141_2 to 141_n-1), the performing comprises:

determining the pointed row address (RA_PTD) as a second fine-grained refresh target row address (RA_TG);

determining a subsequent row address for the pointed row address (RA_PTD) as a third fine-grained refresh target row address (RA_TG); and

refreshing (S270) a third memory cell row corresponding to the second fine-grained refresh target row address (RA_TG) and a fourth memory cell row corresponding to the third fine-grained refresh target row address (RA_TG), simultaneously.

5. The operation method of any one of claims 1 to 4, further comprising:
generating (S260, S280) an updated refresh target pointer value (PT_TG) by updating the refresh target pointer value (PT_TG) based on the first memory cell array type.

6. The operation method of claim 5, wherein the generating comprises:

increasing (S260) the refresh target pointer value (PT_TG) by a first value, when the first memory cell array type is an edge memory cell array type corresponding to the plurality of edge memory cell arrays (141_1, 141_n); and

increasing (S280) the refresh target pointer value (PT_TG) by a second value greater than the first value, when the first memory cell array type is an internal memory cell array type corresponding to the plurality of internal memory cell arrays (141_2 to 141_n-1).

7. The operation method of claim 5 or 6, further comprising:

receiving (S110) a regular refresh command (REF_R);
identifying (S120) the updated refresh target pointer value (PT_TG); and
determining (S140) a plurality of regular refresh target row addresses (RA_TG) based on the updated refresh target pointer value (PT_TG) and the refresh target determination list (LST); and

performing (S140) a second refresh operation for the plurality of regular refresh target row addresses (RA_TG).

8. The operation method of any one of claims 1 to 7, further comprising:

identifying a subsequent row address (RA_SUBS) for the pointed row address (RA_PTD); and

determining a second memory cell array type corresponding to the subsequent row address (RA_SUBS),

wherein the refresh target number is determined further based on the second memory cell array type.

9. A memory device communicating with an external device, the memory device comprising:

a memory bank (140; 240; BNKa to BNKd);
a row decoder (130) connected to the memory bank (140; 240; BNKa to BNKd); and
a control logic circuit (120) configured to manage a refresh target pointer value (PT_TG) and a refresh target determination list (LST) including a plurality of row addresses,
wherein the control logic circuit (120) is configured to:

determine, based on the refresh target pointer value (PT_TG) and the refresh target determination list (LST), a plurality of regular refresh target row addresses (RA_TG) corresponding to a regular refresh command (REF_R) provided from the external device (10); and

determine, based on the refresh target pointer value (PT_TG) and the refresh target determination list (LST), one or more fine-grained refresh target row addresses (RA_TG) corresponding to a fine-grained refresh command (REF_F) provided from the external device (10),
wherein a number of the plurality of regular refresh target row addresses (RA_TG) is greater than a number of the one or more fine-grained refresh target row addresses (RA_TG).

10. The memory device of claim 9, wherein the control logic circuit (120) is configured to:

increase the refresh target pointer value (PT_TG) whenever the regular refresh command (REF_R) is received and whenever the fine-grained refresh command (REF_F) is received.

11. The memory device of claim 10, wherein:

the refresh target determination list (LST) includes a plurality of row address groups,
each of the plurality of row address groups includes a different subset of the plurality of row addresses,
the control logic circuit (120) is configured to determine row addresses included in a row address group, which is one of the plurality of row address groups, corresponding to the refresh target pointer value (PT_TG) as the plurality of regular refresh target row addresses (RA_TG).

12. The memory device of claim 11, wherein:

the memory bank (140; 240; BNKa to BNKd) includes a plurality of edge memory cell arrays (141_1, 141_n), and a plurality of internal memory cell arrays (141_2 to 141_n-1) arranged between the plurality of edge memory cell arrays (141_1, 141_n),
each of the plurality of row address groups includes an even number of edge row addresses corresponding to the plurality of edge memory cell arrays (141_1, 141_n), and
the edge row addresses included in same row address group have a consecutive order within the refresh target determination list (LST).

13. The memory device of claim 12, wherein, among the edge row addresses included in the plurality of row address groups, each of edge row addresses having highest order within each row address group has: an odd numbered order within corresponding row address group.

14. The memory device of claim 12 or 13, wherein: each of the plurality of row address groups includes zero or two edge row addresses.

15. The memory device of claim 13 or 14, wherein the control logic circuit (120) is configured to:

determine, when a pointed row address (RA_PTD) corresponding to the refresh target pointer value (PT_TG) corresponds to the plurality of edge memory cell arrays (141_1, 141_n), the pointed row address (RA_PTD) as the one or more fine-grained refresh target row addresses (RA_TG), and
determine, when the pointed row address (RA_PTD) corresponds to a plurality of internal memory cell rows, the pointed row address (RA_PTD) and a subsequent row address for the pointed row address (RA_PTD) as the one or more fine-grained refresh target row addresses (RA_TG).

# FIG. 1

EP 4 682 882 A2

MS

## Host device (10)

- Command issuance circuit (11)
- Refresh debit counter [DCNT] (12)
- Timer circuit (13)
- Refresh scheduling circuit (14)

CMD [REF_R, REF_F]

ADDR

DATA

## Memory device (100)

- Control logic circuit (120)
  - Refresh manager (121)
- Memory bank (MCRs) (140)

# FIG. 2

# FIG. 4

# FIG. 5

100

EP 4 682 882 A2

# FIG. 6

# FIG. 7

⋮

| BLSA #2 (142_2) |
|---|

MEMORY CELL ARRAY #3 ~141_3

~MCRa

| BLSA #3 (142_3) |
|---|

MEMORY CELL ARRAY #4 ~141_4

| BLSA #4 (142_4) |
|---|

MEMORY CELL ARRAY #5 ~141_5

~MCRb

| BLSA #5 (142_5) |
|---|

⋮

# FIG. 8

CMD

Memory bank operation

tREC_R

REF_R

ACT
REF_R
REF_F

Regular refresh

t1                    t2        t3    Time

# FIG. 9

# FIG. 10

LSTa

| | |
|---|---|
| RA0 | |
| RA1 | |
| RA2 | |
| RA3 | ① Refreshed by REF_R1 |
| RA4 | |
| RA5 | |
| RA6 | |
| RA7 | |
| RA8 | ② Refreshed by REF_F1 |
| RA9 | |
| RA10 | ③ Refreshed by REF_F2 |
| RA11 | |
| RA12 [edge] | ④ Refreshed by REF_F3 |
| RA13 | |
| RA14 | |
| RA15 | |
| RA16 | ⑤ Refreshed by REF_R2 |
| RA17 | |
| RA18 | |

Refresh sequentially

FIG. 11

# FIG. 12

LSTb

RAGa — ① Refreshed by REF_R1 (RA0–RA7)

RAGb

② Refreshed by REF_F1 (RA8, RA9)
③ Refreshed by REF_F2 (RA10, RA11)
④ Refreshed by REF_F3 (RA12 [edge])
⑤ Refreshed by REF_R2

Refresh sequentially

RA0
RA1
RA2
RA3
RA4
RA5
RA6
RA7
RA8
RA9
RA10
RA11
RA12 [edge]
RA13
RA14
RA15
RA16
RA17
RA18

EP 4 682 882 A2

FIG. 13

# FIG. 14

```
                    ( START )
                        │
                        ▼
          ┌──────────────────────────┐
          │       Receive REF_R       │──── S110
          └──────────────────────────┘
                        │
                        ▼
          ┌──────────────────────────┐
          │      Identify PT_TG       │──── S120
          └──────────────────────────┘
                        │
                        ▼
          ┌──────────────────────────────────┐
          │ Determine a plurality of RA_TG for │
          │        REF_R based on the PT_TG    │──── S130
          └──────────────────────────────────┘
                        │
                        ▼
          ┌──────────────────────────┐
          │  Refresh MCRs corresponding to │
          │    the plurality of RA_TG      │──── S140
          └──────────────────────────┘
                        │
                        ▼
          ┌──────────────────────────┐
          │       Update PT_TG        │──── S150
          └──────────────────────────┘
                        │
                        ▼
                    ( END )
```

# FIG. 15

```
                    ( START )
                        │
                        ▼
S210──┌─────────────────────────────┐
      │        Receive REF_F         │
      └─────────────────────────────┘
                        │
                        ▼
S220──┌─────────────────────────────┐
      │        Identify PT_TG        │
      └─────────────────────────────┘
                        │
                        ▼
S230──┌─────────────────────────────┐
      │ Identify RA_PTD and RA_SUBS  │
      │  corresponding to the PT_TG  │
      └─────────────────────────────┘
                        │
                        ▼
                                  S240
              ╱─────────────────╲
            ╱   RA_PTD or         ╲          No
          ╱  RA_SUBS corresponds to ╲──────────────────┐
          ╲   edge memory cell array? ╱                 │
            ╲                       ╱                    │
              ╲─────────────────╱                       │
                        │ Yes                            ▼
                        ▼                    ┌─────────────────────────┐
S250──┌─────────────────────────┐           │ Refresh two MCRs         │
      │ Refresh one or more MCR  │           │ respectively             │──S270
      │ corresponding to the     │           │ corresponding to the     │
      │ RA_PTD                   │           │ RA_PTD and RA_SUBS       │
      └─────────────────────────┘           └─────────────────────────┘
                        │                                │
                        ▼                                ▼
S260──┌─────────────────────────┐           ┌─────────────────────────┐
      │    Increase PT_TG by 1   │           │   Increase PT_TG by 2    │──S280
      └─────────────────────────┘           └─────────────────────────┘
                        │                                │
                        ▼◄───────────────────────────────┘
                    ( END )
```

# FIG. 16

# FIG. 17

EP 4 682 882 A2

FIG. 18

# FIG. 19

Data bus efficiency

- - - - Refresh based on REF_R only
———— refresh based on both of REF_R and REF_F

Data transmission rate

# FIG. 20

START

S310 — Identify that tREFI has elapsed

S320 — Increase DCNT by CST_SKIP

S330 — Determine whether to issue REF_R based on DCNT

S340 — Determine to issue REF_R?

No

Yes

S350 — Issue REF_R and decrease the DCNT based on the CST_SKIP

S360 — Skip issuing REF_R and maintain the DCNT

END

# FIG. 21

START

S410

Appropriate to issue REF_F? — No

Yes

S420 — Issue REF_F

S430 — Decrease DCNT by 1

END

# FIG. 22

LSTc

Refresh sequentially

RAGc

| RAa | ① Refreshed by REF_Fa |
| RAb | |
| RAc | ② Refreshed by REF_Fb |
| RAd | |
| RAe [edge] | ③ Refreshed by REF_Fc |
| RAf [edge] | ④ Refreshed by REF_Fd |
| RAg | ⑤ Refreshed by REF_Fe |
| RAh | |

FIG. 23

START

S510 — Receive REF_F

S520 — Identify PT_TG

S530 — Identify RA_PTD corresponding to the PT_TG

S540 — RA_PTD corresponds to edge memory cell array?

No

Yes

S550 — Refresh two MCRs corresponding to the RA_PTD

S570 — Refresh two MCRs respectively corresponding to the RA_PTD and RA_SUBS

S560 — Increase PT_TG by 1

S580 — Increase PT_TG by 2

END

# FIG. 24

MS

# FIG. 25

# FIG. 26

EP 4 682 882 A2

# FIG. 27

EP 4 682 882 A2